# EUROPEAN PATENT APPLICATION

(11) **EP 4 769 066 A1**
(43) Date of publication of application: **01.07.2026**
(21) Application number: 25835358.0
(22) Date of filing: 16.09.2025
(51) Int. Cl.: G06F 1/16, G09F 9/30, H05K 5/02, H04M 1/02, F16C 11/04

(54) **FOLDABLE ELECTRONIC DEVICE COMPRISING SUPPORT ASSEMBLY**

(30) Priority: 15.10.2024 KR 20240140195; 08.11.2024 KR 20240157978
(71) Applicant: Samsung Electronics Co., Ltd., Suwon-si, Gyeonggi-do 16677 (KR)
(72) Inventor: JUNG, Minsu, Suwon-si, Gyeonggi-do 16677 (KR); LA, Hyosung, Suwon-si, Gyeonggi-do 16677 (KR); LEE, Changmin, Suwon-si, Gyeonggi-do 16677 (KR)
(74) Representative: Gulde & Partner
(86) International application number: PCT/KR2025/014389
(87) International publication number: WO 2026/084270

(57) **Abstract**

A foldable electronic device according to an embodiment may include a foldable housing including a first housing, a second housing and a hinge housing, a hinge assembly disposed at least in part within the hinge housing, and rotatably connecting the first housing and the second housing, a flexible display crossing the hinge assembly, and disposed at least in part within the first housing and the second housing, and a supporting assembly for supporting at least in part the flexible display. The supporting assembly may include a first fixing member coupled to the hinge housing, a second fixing member coupled to the first fixing member, and a moving member configured to be movable within a space between the first fixing member and the second fixing member. In an unfolded state of the foldable electronic device, one surface of the first fixing member and one surface of the moving member may support at least in part the flexible display. In a folded state of the foldable electronic device, the one surface of the moving member may form a step with the one surface of the first fixing member.

## Description

### [Technical Field]

The disclosure relates to a foldable electronic device including a supporting assembly.

### [Background Art]

As technology advances, an electronic device is evolving to become lighter and thinner for portability and convenience. For example, a foldable electronic device equipped with a flexible display is configured to provide a relatively greater screen than a typical bar-type electronic device and to be folded and unfolded, thus improving the portability of the electronic device.

Hence, research is actively conducted on a structure of the electronic device for securing durability of the flexible display which is folded and unfolded together while the foldable electronic device is folded and unfolded. In particular, securing the durability of a folding portion of the flexible display corresponding to a hinge allowing to fold the electronic device may determine quality of the foldable electronic device.

The foregoing information may be provided as related art for the purpose of aiding understanding of the disclosure. No claim or determination is made as to whether any of the foregoing may be applied as the prior art in connection with the disclosure.

### [Disclosure of Invention]

### [Solution to Problem]

According to an embodiment of the disclosure, a foldable electronic device may include a foldable housing including a first housing, a second housing and a hinge housing. The foldable electronic device may include a hinge assembly disposed at least in part within the hinge housing, and rotatably connecting the first housing and the second housing. The foldable electronic device may include a flexible display crossing the hinge assembly, and disposed at least in part within the first housing and the second housing. The foldable electronic device may include a supporting assembly for supporting at least in part the flexible display. The supporting assembly may include a first fixing member coupled to the hinge housing. The supporting assembly may include a second fixing member coupled to the first fixing member. The supporting assembly may include a moving member configured to be movable within a space between the first fixing member and the second fixing member. In an unfolded state of the foldable electronic device, one surface of the first fixing member and one surface of the moving member may support at least in part the flexible display. In a folded state of the foldable electronic device, the one surface of the moving member may form a step with the one surface of the first fixing member.

According to an embodiment of the disclosure, a foldable electronic device may include a foldable housing including a first housing, a second housing and a hinge housing. The foldable electronic device may include a hinge assembly disposed at least in part within the hinge housing, and rotatably connecting the first housing and the second housing. The foldable electronic device may include a flexible display crossing the hinge assembly, and disposed at least in part within the first housing and the second housing. The foldable electronic device may include a supporting assembly for supporting at least in part the flexible display. The supporting assembly may include a first fixing member coupled to the hinge housing. The supporting assembly may include a second fixing member coupled to the first fixing member. The supporting assembly may include a moving member configured to be movable within a space between the first fixing member and the second fixing member. In an unfolded state of the foldable electronic device, as the moving member is lifted, one surface of the moving member may support a folding portion of the flexible display. In a folded state of the foldable electronic device, as the moving member descends, the folding portion of the flexible display may be positioned at least in part within a recess formed by a side surface of the first fixing member and the one surface of the moving member.

### [Brief Description of Drawings]

FIG. 1 is a front perspective view of a device according to an embodiment.
FIG. 2 is a rear plan view of an electronic device according to an embodiment.
FIG. 3 is a perspective view of a foldable electronic device in an unfolded state according to an embodiment.
FIG. 4 is a perspective view of a foldable electronic device in a folded state according to an embodiment.
FIG. 5 is an exploded perspective view of a foldable electronic device according to an embodiment.
FIG. 6 is a cross-sectional view of a section A-A' of FIG. 3 according to an embodiment.
FIG. 7 is a cross-sectional view of a section B-B' of FIG. 4 according to an embodiment.
FIG. 8 is an exploded perspective view of a supporting assembly according to an embodiment.
FIG. 9 is a front perspective view of a supporting assembly according to an embodiment.
FIG. 10 is a rear view of a supporting assembly according to an embodiment.
FIG. 11 is a perspective view of a hinge assembly and a supporting assembly of a foldable electronic device in an unfolded state according to an embodiment.
FIG. 12 is a perspective view of a hinge assembly and a supporting assembly of a foldable electronic device in a folded state according to an embodiment.
FIG. 13 is a cross-sectional view of a section C-C' of FIG. 11 according to an embodiment.
FIG. 14 is a cross-sectional view of a section E-E' of FIG. 12 according to an embodiment.
FIG. 15 is a cross-sectional view of a section D-D' of FIG. 11 according to an embodiment.
FIG. 16 is a cross-sectional view of a section F-F' of FIG. 12 according to an embodiment.
FIG. 17 is a cross-sectional view of a section G-G' of FIG. 11 according to an embodiment.
FIG. 18 is a cross-sectional view of a section H-H' of FIG. 12 according to an embodiment.
FIG. 19 is a perspective view of a first moving member formed of an elastic material according to an embodiment.
FIG. 20 is a front view of a first moving member formed of an elastic material in an unfolded state of a foldable electronic device according to an embodiment.
FIG. 21 is a front view of a first moving member formed of an elastic material in a folded state of a foldable electronic device according to an embodiment.
FIG. 22 is a view illustrating an unfolded state of a foldable electronic device including a magnetic body according to an embodiment.
FIG. 23 is a view illustrating a folded state of a foldable electronic device including a magnetic body according to an embodiment.
FIG. 24 is a block diagram of an electronic device in a network environment according to an embodiment.

In relation to descriptions of the drawings, like or similar reference numerals may be used for like or similar components.

### [Mode for the Invention]

Hereinafter, various embodiments of the invention are described with reference to the accompanying drawings. However, this is not intended to limit the invention to any particular embodiment and is to be understood to include various modifications, equivalents, and/or alternatives of the embodiments of the invention.

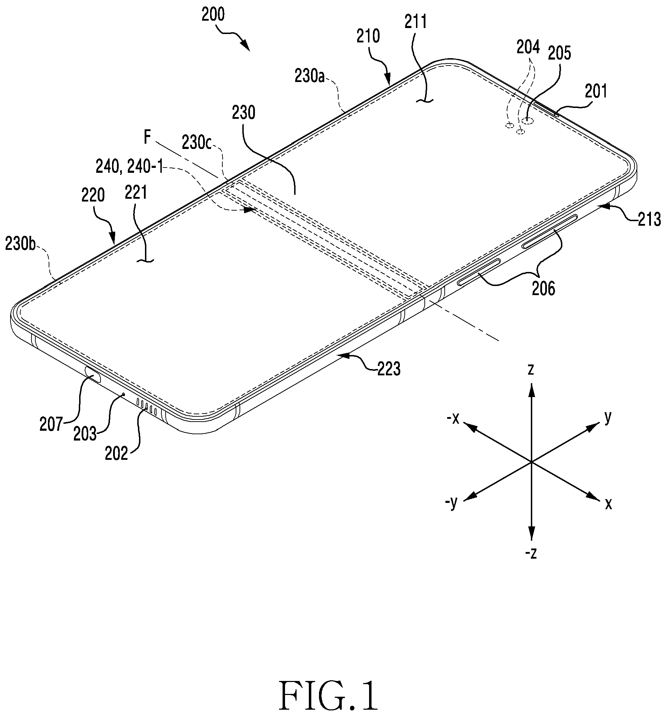

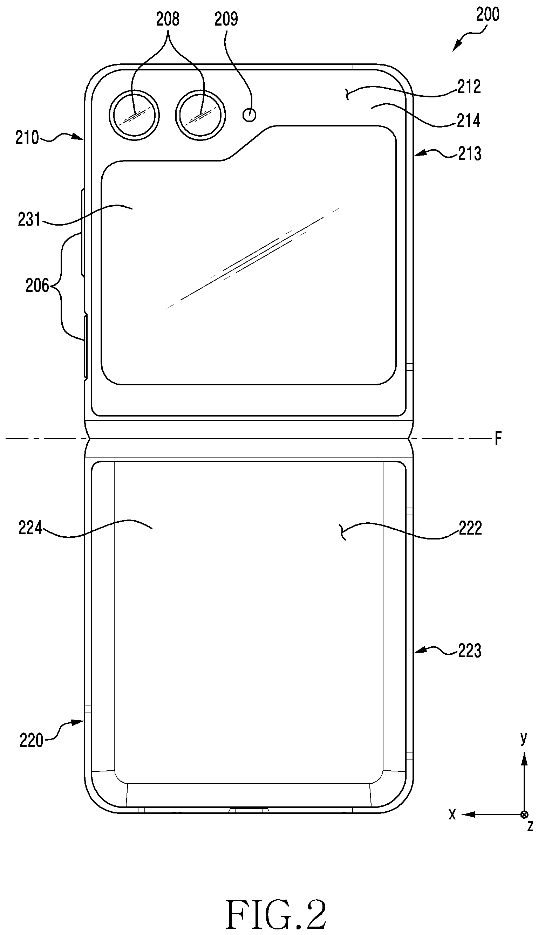

FIG. 1 is a front perspective view of an electronic device according to an embodiment. FIG. 2 is a rear plan view of an electronic device according to an embodiment.

Referring to FIG. 1 and FIG. 2, an electronic device 200 may include a first housing 210 (e.g., a first housing structure) including a first side member 213 (e.g., a side bezel) and a second housing 220 (e.g., a second housing structure) including a second side member 223 (e.g., a side bezel), which are foldably coupled to each other through at least one hinge device 240 and 240-1 (e.g., a hinge module or a hinge structure), based on a folding axis F. For example, the first housing 210 and the second housing 220 may be configured as a foldable housing (e.g., a housing structure). For example, the electronic device 200 may include a first display 230 (e.g., a flexible display, a foldable display, or a main display) disposed to be supported by the first housing 210 and the second housing 220. For example, the first housing 210 may include a first surface 211 and a second surface 212 facing away from the first surface 211 (e.g., in the -z axis direction). For example, the second housing 220 may include a third surface 221 and a fourth surface 222 facing away from the third surface 221 (e.g., in the -z axis direction). For example, the first housing 210 may include a first rear cover 214 coupled to the first side member 213. For example, the second housing 220 may include a second rear cover 224 coupled to the second side member 223. For example, the electronic device 200 may be operated to cause, in a first state (e.g., an unfolded state or a flat state) fully unfolded, the first surface 211 and the third surface 221 to face in substantially the same direction (e.g., in the z-axis direction). For example, the electronic device 200 may be operated to cause, in a second state (e.g., a folded state or a folding state) fully folded, the first surface 211 and the third surface 221 to face each other, or to face away from each other. For example, the electronic device 200 may be operated to maintain a third state (e.g., an intermediate state) between the first state and the second state.

According to an embodiment, the electronic device 200 may include a first receiver 201 disposed in the first surface 211 of the first housing 210, at least one first sensor module 204 (e.g., a light sensor) and/or at least one first camera module 205 (e.g., an under display camera, UDC). For example, the electronic device 200 may include at least one key 206 disposed in the one side member 213. For example, the electronic device 200 may include at least one second camera module 208 and/or a flash 209 disposed in the second surface 212 (e.g., the first rear cover 214) of the first housing 210. For example, the electronic device 200 may include a second display 231 disposed in the fourth surface 222 of the second housing 220, at least one third camera module 225 (e.g., a UDC), at least one second sensor module 226 and/or a second receiver 227. For example, the second display 231 may be disposed to be visible from outside through at least a part of the second rear cover 224. For example, the electronic device 200 may include a speaker 202 disposed in the second side member 223, a microphone 203 disposed in the second side member 213 and/or a connector port 207. At least some of the plurality of components mentioned above may be disposed in the first housing 210 and/or the second housing 220.

According to an embodiment, the first display 230 (e.g., a flexible display) may include a first region 230a (e.g., a first planar portion) corresponding to at least a part of the first surface 211, a second region 230b (e.g., a second planar portion) corresponding to at least a part of the third surface 221, and a third region 230c (e.g., a third planar portion) connecting the first region 230a and the second region 230b and deformed in the second state (e.g., the folded state) and/or the third state of the electronic device 200. For example, the third region 230c may be disposed at a position overlapping at least in part the at least one hinge device 240 and 240-1, when the first display 230 is viewed from above (e.g., in the z-axis direction). For example, the first display 230 may be disposed such that, in the second state, the first surface 211 and the third surface 221 face each other not to viewed from the outside (e.g., inward-fold type). For example, the first display 230 may be disposed such that, in the second state, the first surface 211 and the third surface 221 face away from each other to be viewed from the outside (e.g., outward-fold type).

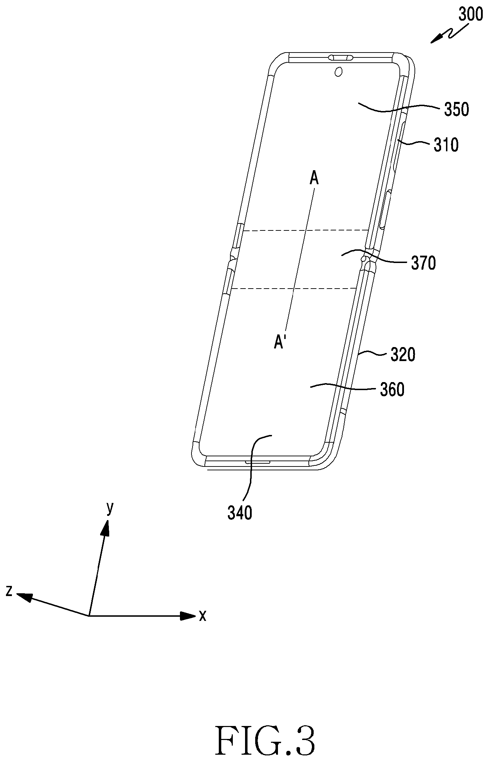

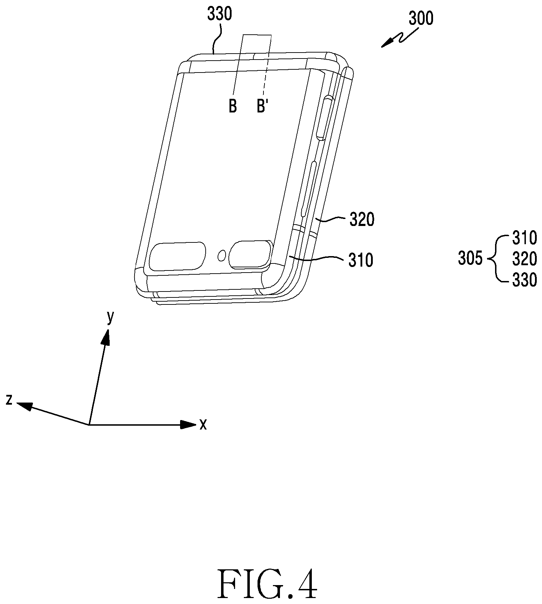

FIG. 3 is a perspective view of a foldable electronic device in an unfolded state according to an embodiment. FIG. 4 is a perspective view of a foldable electronic device in a folded state according to an embodiment.

According to an embodiment of the disclosure, a foldable electronic device 300 may include a foldable housing 305 including a first housing 310, a second housing 320 and a hinge housing 330, and a flexible display 340. For example, the foldable electronic device 300 may correspond to the electronic device 200 of FIG. 1 and FIG. 2. For example, the foldable housing 305 may correspond to the foldable housing of FIG. 1 and FIG. 2. For example, the first housing 310 may correspond to the first housing 210 of FIG. 1 and FIG. 2. For example, the second housing 320 may correspond to the second housing 220 of FIG. 1 and FIG. 2. For example, the flexible display 340 may correspond to the first display 230 of FIG. 1 and FIG. 2.

According to an embodiment of the disclosure, referring to FIG. 3 and FIG. 4, the hinge housing 330 may be disposed between the first housing 310 and the second housing 320. For example, the hinge housing 330 may be integrally formed with the first housing 310 and the second housing 320, or may be formed as a separate member. According to an embodiment, the flexible display 340 may be disposed at least in part within the foldable housing 305. For example, the flexible display 340 may include a first display portion 350, a second display portion 360 and a folding portion 370.

According to an embodiment of the disclosure, referring to FIG. 3, for example, the first display portion 350 of the flexible display 340 may be disposed at least in part within the first housing 310. For example, the second display portion 360 of the flexible display 340 may be disposed at least in part within the second housing 320. For example, the folding portion 370 of the flexible display 340 may be disposed at least in part within the hinge housing 330. For example, the folding portion 370 of the flexible display 340 may be a portion which is folded or unfolded as the foldable electronic device 300 is folded or unfolded.

According to an embodiment of the disclosure, referring to FIG. 3, in the first state of the foldable electronic device 300 unfolded, the first housing 310 and the second housing 320 may be disposed substantially in parallel. For example, in the first state of the foldable electronic device 300, the first housing 310 and the second housing 320 may be disposed to face in the +z-axis direction. For example, in the first state of the foldable electronic device 300, the first display portion 350 and the second display portion 360 of the flexible display 340 may be disposed substantially in parallel. For example, in the first state of the foldable electronic device 300, the first display portion 350 and the second display portion 360 of the flexible display 340 may be disposed to face in the +z-axis direction.

According to an embodiment of the disclosure, referring to FIG. 4, in the second state of the foldable electronic device 300 folded, the first housing 310 may be disposed on the second housing 320. For example, in the second state of the foldable electronic device 300, the first housing 310 may be disposed to face the second housing 320. For example, in the second state of the foldable electronic device 300, the first display portion 350 and the second display portion 360 of the flexible display 340 may be disposed to face each other.

According to an embodiment of the disclosure, referring to FIG. 3 and FIG. 4, while the state of the foldable electronic device 300 changes from the first state to the second state, the first housing 310 and the second housing 320 may move close to each other. For example, while the state of the foldable electronic device 300 changes from the first state to the second state, the first display portion 350 and the second display portion 360 may move close to each other. According to an embodiment, while the state of the foldable electronic device 300 changes from the second state to the first state, the first housing 310 and the second housing 320 may move away from each other. For example, while the state of the foldable electronic device 300 changes from the second state to the first state, the first display portion 350 and the second display portion 360 may move away from each other.

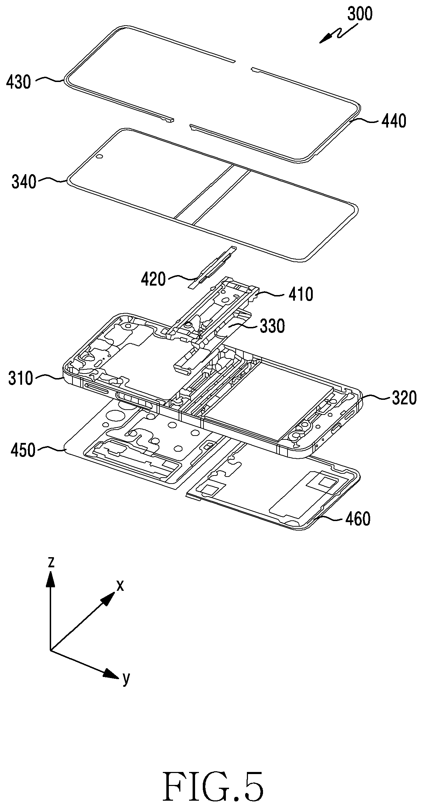

FIG. 5 is an exploded perspective view of a foldable electronic device according to an embodiment.

According to an embodiment of the disclosure, the foldable electronic device 300 may further include a hinge assembly 410, a supporting assembly 420, a first decorative member 430, a second decorative member 440, a first rear cover 450 and a second rear cover 460.

According to an embodiment of the disclosure, the hinge assembly 410 may rotatably connect the first housing 310 and the second housing 320. For example, the first housing 310 may be coupled to one side of the hinge assembly 410. For example, the second housing 320 may be coupled to the other side of the hinge assembly 410 which is opposite to the one side. For example, the first housing 310 and the second housing 320 may be rotated by the hinge assembly 410, and the foldable electronic device 300 may be folded or unfolded as the first housing 310 and the second housing 320 are rotated.

According to an embodiment of the disclosure, the hinge assembly 410 may be disposed between the hinge housing 330 and the flexible display 340. For example, the hinge assembly 410 may be disposed at least in part within the hinge housing 330. For example, the hinge assembly 410 may be disposed at a position corresponding to the folding portion 370 of the flexible display 340. For example, as the foldable electronic device 300 is folded or unfolded by the hinge assembly 410, the folding portion 370 of the flexible display 340 may be folded or unfolded.

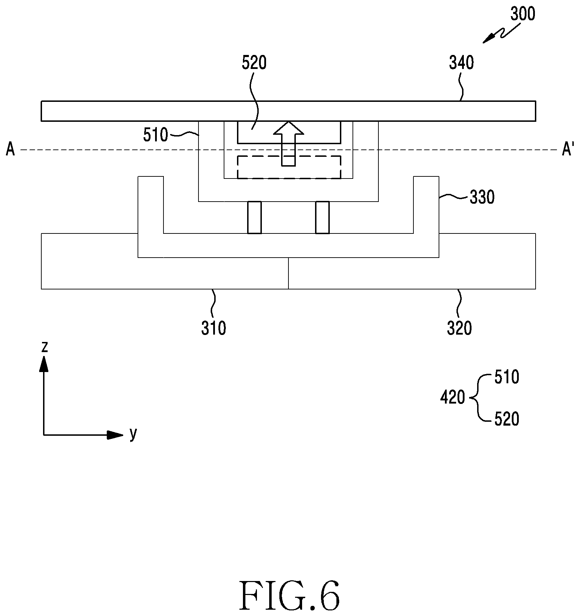

According to an embodiment of the disclosure, the supporting assembly 420 may be disposed between the flexible display 340 and the hinge assembly 410. For example, the supporting assembly 420 may be disposed at a position corresponding to the folding portion 370 of the flexible display 340. For example, while the foldable electronic device 300 is folded or unfolded, the supporting assembly 420 may support the flexible display 340. According to an embodiment, the supporting assembly 420 may be disposed at least in part in the hinge assembly 410. For example, the supporting assembly 420 may be disposed in a center portion of the hinge assembly 410. For example, the supporting assembly 420 may be seated in the center portion of the hinge assembly 410. The structure of the supporting assembly 420 shall be described in detail with reference to FIG. 6 through FIG. 10.

According to an embodiment of the disclosure, the first decorative member 430 and the second decorative member 440 may protect the flexible display 340. For example, the first decorative member 430 may be disposed to surround at least a part of a periphery of the first display portion 350 of the flexible display 340. For example, the second decorative member 440 may be disposed to surround at least a part of a periphery of the second display portion 360 of the flexible display 340.

According to an embodiment of the disclosure, the first rear cover 450 and the second rear cover 460 may form at least a part of an exterior of the foldable electronic device 300. For example, the first rear cover 450 may be formed to cover at least a part of a rear surface facing in the -z-axis of the first housing 310. For example, the second rear cover 460 may be formed to cover at least a part of a rear surface facing in the -z-axis of the second housing 320.

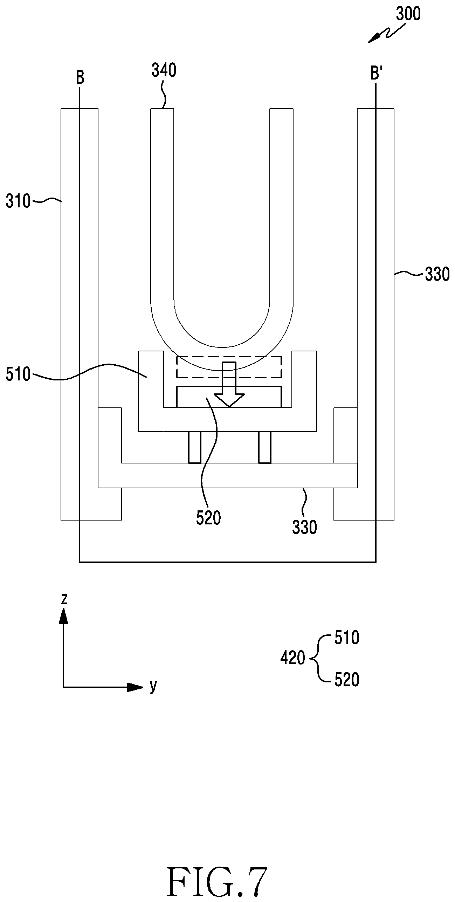

FIG. 6 is a cross-sectional view of a section A-A' of FIG. 3 according to an embodiment. FIG. 7 is a cross-sectional view of a section B-B' of FIG. 4 according to an embodiment. For example, FIG. 6 and FIG. 7 may be the views illustrating movement of a moving member 520 of the supporting assembly 420 while the foldable electronic device 300 is unfolded or folded.

According to an embodiment of the disclosure, the supporting assembly 420 may include a fixing member 510 and a moving member 520. For example, the supporting assembly 420 may be disposed at least in part within the hinge housing 330. For example, the fixing member 510 of the supporting assembly 420 may be coupled to the hinge housing 330. For example, the fixing member 510 may be coupled to the hinge housing 330 and secured to the hinge housing 330.

According to an embodiment of the disclosure, the moving member 520 of the supporting assembly 420 may be configured to move within a space formed by the fixing member 510. For example, referring to FIG. 6, as the state of the foldable electronic device 300 changes from the second state to the first state, the moving member 520 may be lifted. For example, as the state of the foldable electronic device 300 changes from the second state to the first state, the moving member 520 may be moved in a direction approaching the flexible display 340. For example, as the state of the foldable electronic device 300 changes from the second state to the first state, the moving member 520 may be moved in the +z-axis direction.

According to an embodiment of the disclosure, referring to FIG. 7, as the state of the foldable electronic device 300 changes from the first state to the second state, the moving member 520 may descend. For example, as the state of the foldable electronic device 300 changes from the first state to the second state, the moving member 520 may be moved away from the flexible display 340. For example, as the state of the foldable electronic device 300 changes from the first state to the second state, the moving member 520 may be moved in the - z-axis direction.

According to an embodiment of the disclosure, referring to FIG. 6, in the unfolded state of the foldable electronic device 300, the moving member 520 may support at least in part the flexible display 340 together with the fixing member 510. For example, in the unfolded state of the foldable electronic device 300, the moving member 520 may support the folding portion 370 of the flexible display 340 to prevent the folding portion 370 of the flexible display 340 from sagging in the -z-axis direction.

According to an embodiment of the disclosure, referring to FIG. 7, while the foldable electronic device 300 is folded, the moving member 520 may be moved away from the flexible display 340 to block the moving member 520 from interfering with the flexible display 340. According to an embodiment, in the folded state of the foldable electronic device 300, a recess may be formed by the fixing member 510 and the moving member 520. For example, the recess may be concavely formed in the -z-axis direction. For example, the flexible display 340 may be disposed at least in part within the recess. For example, the folding portion 370 of the flexible display 340 may be positioned at least in part within the recess. For example, the folding portion 370 may be positioned between a top surface of the fixing member 510 facing in the +z-axis and a top surface of the moving member 520 facing in the +z-axis.

In this disclosure, as shown in FIG. 6, the position at which the moving member 520 supports at least a part of the unfolded flexible display 340 may be referred to as a first position. As shown in FIG. 7, the position at which the moving member 520 moves from the first position to form the space in which the folded flexible display 340 is disposed may be referred to as a second position.

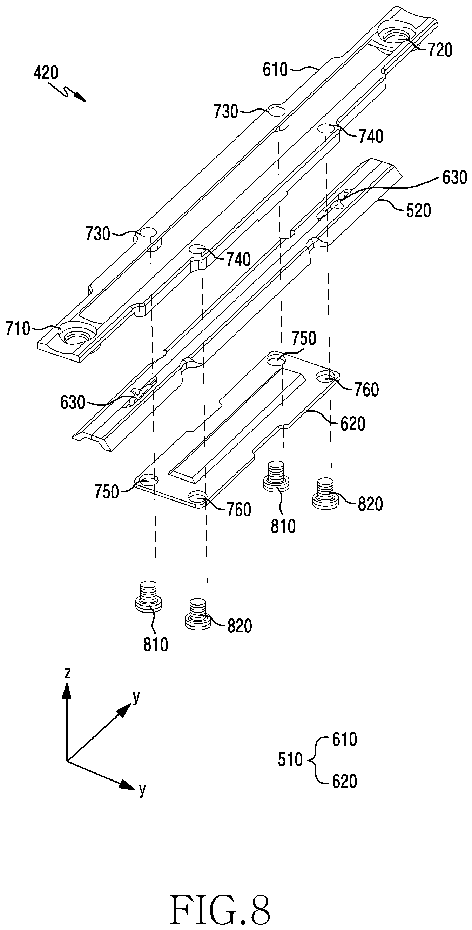

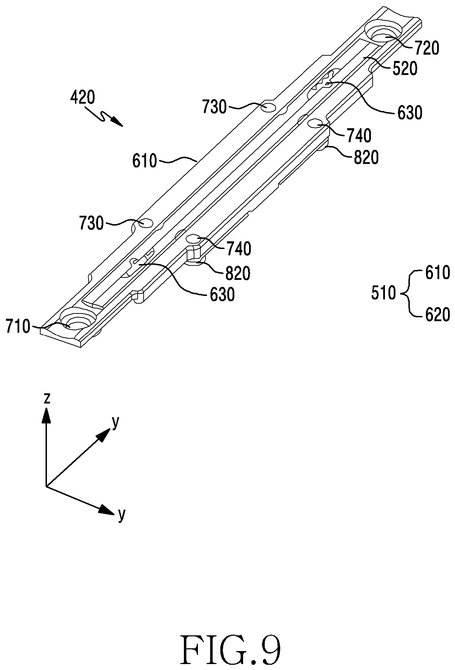

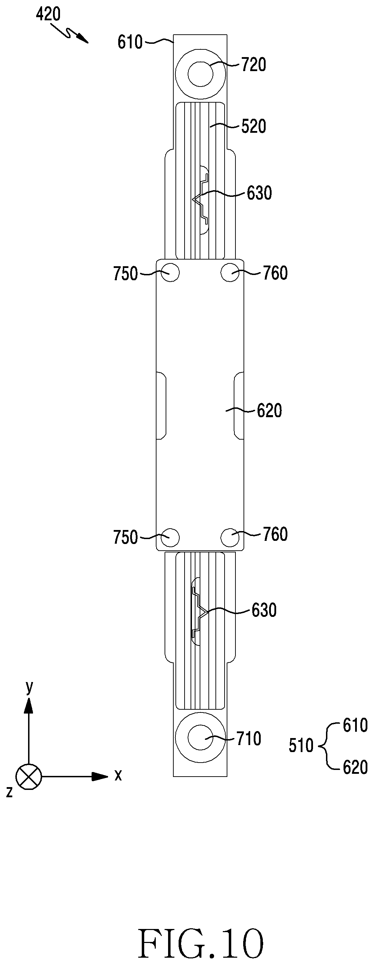

FIG. 8 is an exploded perspective view of a supporting assembly according to an embodiment. FIG. 9 is a front perspective view of a supporting assembly according to an embodiment. FIG. 10 is a rear view of a supporting assembly according to an embodiment.

According to an embodiment of the disclosure, the fixing member 510 may include a first fixing member 610 and a second fixing member 620. According to an embodiment, the first fixing member 610 may include a first opening 710 and a second opening 720. For example, the first opening 710 may be formed at one end of the first fixing member 610. For example, the second opening 720 may be formed at the other end opposite to the one end of the first fixing member 610. For example, the first fixing member 610 may be coupled to the hinge housing 330 through the first opening 710 and the second opening 720. For example, the first fixing member 610 may be secured to the hinge housing 330 by a plurality of fasteners disposed to pass through the first opening 710 and the second opening 720.

According to an embodiment of the disclosure, the first fixing member 610 may include at least one third opening 730 and at least one fourth opening. For example, the at least one third opening 730 may be formed on one side of the first fixing member 610. For example, the at least one fourth opening 740 may be formed on the other side which is opposite to one side of the first fixing member 610. For example, one side and the other side of the first fixing member 610 may extend from one end where the first opening 710 is formed and the other end where the second opening 720 is formed, and may be positioned between one end and the other end. For example, one side and the other side of the first fixing member 610 may be formed by spacing apart from each other. For example, a space may be formed between one side and the other side of the first fixing member 610.

According to an embodiment of the disclosure, the second fixing member 620 may include at least one fifth opening 750 and at least one sixth opening 760. For example, the at least one fifth opening 750 and the at least one sixth opening 760 may be formed along an edge of the second fixing member 620. For example, the at least one fifth opening 750 may be formed on one side of the second fixing member 620, and the at least one sixth opening 760 may be formed on the other side opposite to one side of the second fixing member 620. For example, the at least one fifth opening 750 may be formed at a position corresponding to the at least one third opening 730. For example, the at least one sixth opening 760 may be formed at a position corresponding to the at least one fourth opening 740.

According to an embodiment of the disclosure, the second fixing member 620 may be coupled to the first fixing member 610. For example, one side of the second fixing member 620 may be coupled to one side of the first fixing member 610 by at least one first fastening member 810 disposed to penetrate the at least one third opening 730 and the at least one fifth opening 750. For example, the other side of the second fixing member 620 may be coupled to the other side of the first fixing member 610 by at least one second fastening member 820 disposed to penetrate the at least one fourth opening 740 and the at least one sixth opening 760.

According to an embodiment of the disclosure, the moving member 520 may be disposed between the first fixing member 610 and the second fixing member 620. For example, the moving member 520 may be disposed within the space formed by the first fixing member 610 and the second fixing member 620. For example, the moving member 520 may be configured to be movable within the space formed by the first fixing member 610 and the second fixing member 620.

According to an embodiment of the disclosure, the moving member 520 may include at least one recess. For example, the at least one recess may be concavely formed to a specific depth in a direction parallel to the y-axis. For example, if a plurality of at least one recesses is provided, the recess may be formed at a top portion and a bottom portion of the moving member 520, but is not limited to.

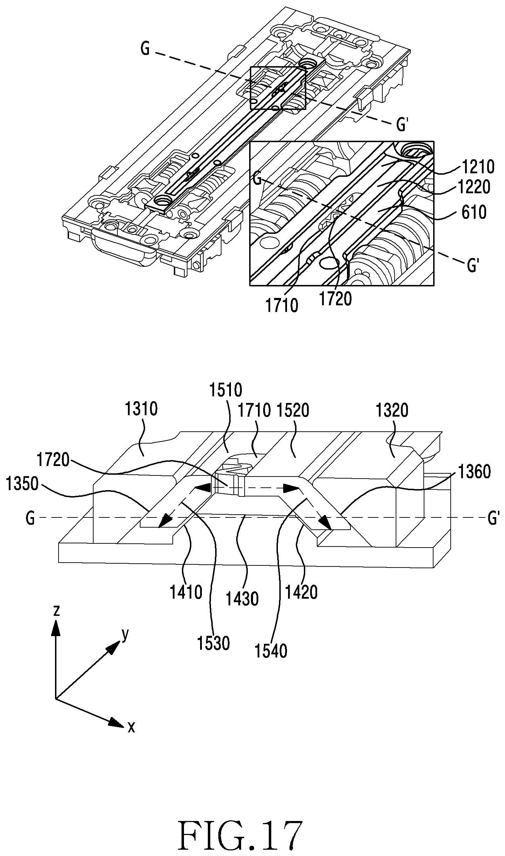

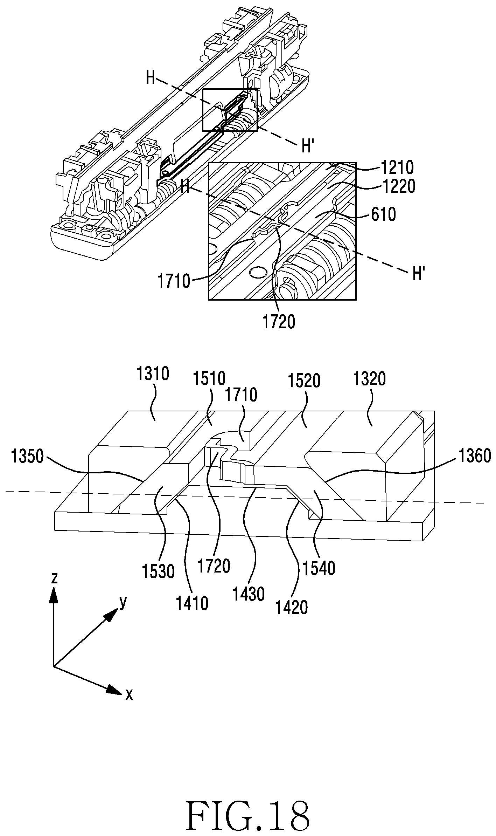

According to an embodiment of the disclosure, the foldable electronic device 300 may include an elastic member 630. For example, the elastic member 630 may be disposed within the recess formed in the moving member 520. For example, the elastic member 630 may be formed as a plate-shaped spring (e.g. a leaf spring). According to an embodiment, the moving member 520 may be configured to integrally move within the space between the first fixing member 610 and the second fixing member 620, but if the moving member 520 includes a first moving member 1210 and a second moving member 1220 to be described in FIG. 17 and FIG. 18, the elastic member 630 may be configured to push the first moving member 1210 and the second moving member 1220 in a direction parallel to the y-axis during the folding process of the foldable electronic device 300. For example, the moving member 520 divided into the first moving member 1210 and the second moving member 1220 may be configured to be moved by the elastic member 630 in the z-axis direction within the space between the first fixing member 610 and the second fixing member 620.

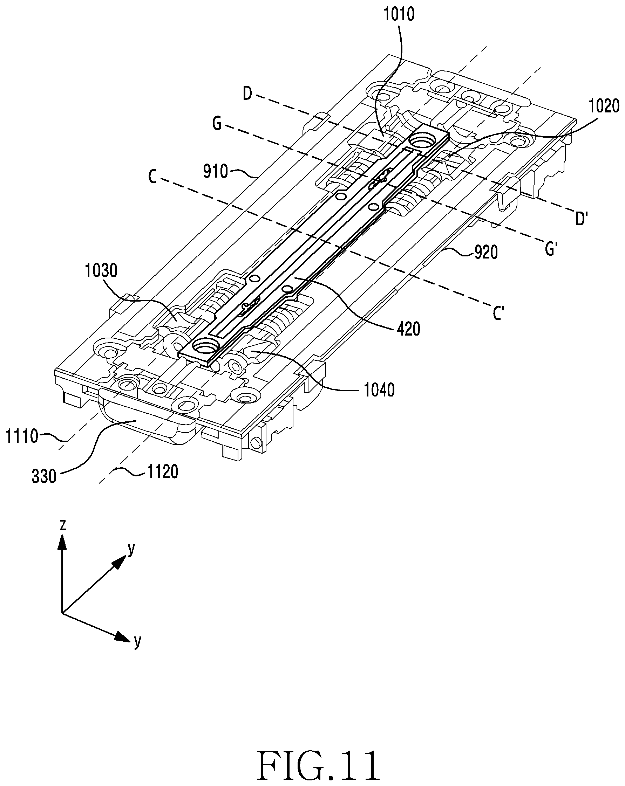

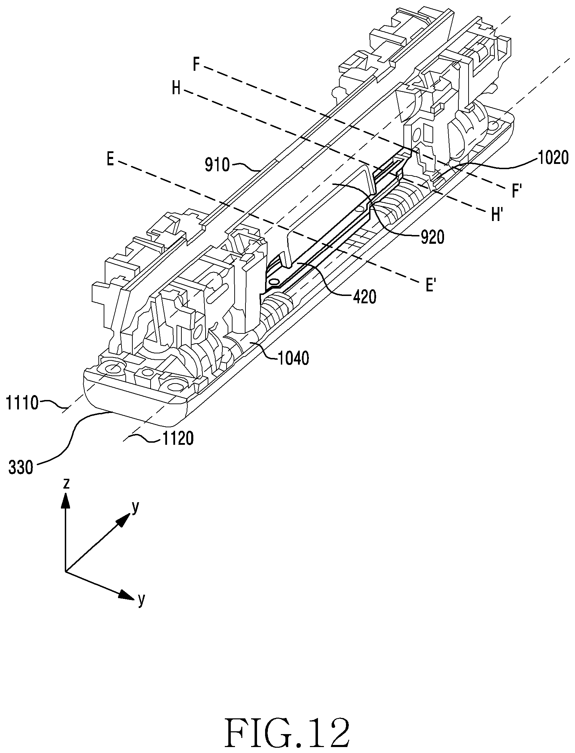

FIG. 11 is a perspective view of a hinge assembly and a supporting assembly of a foldable electronic device in an unfolded state according to an embodiment. FIG. 12 is a perspective view of a hinge assembly and a supporting assembly of a foldable electronic device in a folded state according to an embodiment.

According to an embodiment of the disclosure, the hinge assembly 410 may include a first rotating member 910, a second rotating member 920, a first rotating arm 1010, a second rotating arm 1020, a third rotating arm 1030 and a fourth rotating arm 1040.

According to an embodiment of the disclosure, the supporting assembly 420 may be seated on a central portion of the hinge housing 330. For example, the first rotating arm 1010 and the third rotating arm 1030 may be disposed adjacent to one side of the supporting assembly 420. For example, the second rotating arm 1020 and the fourth rotating arm 1040 may be disposed adjacent to the other side opposite to the one side of the supporting assembly 420. According to an embodiment, the first rotating arm 1010 and the third rotating arm 1030 may rotate about a first rotation axis 1110. According to an embodiment, the second rotating arm 1020 and the fourth rotating arm 1040 may rotate about a second rotation axis 1120 which is substantially parallel to the first rotation axis 1110.

According to an embodiment of the disclosure, the first rotating member 910 may be connected to the first rotating arm 1010 and the third rotating arm 1030. For example, as the first rotating arm 1010 and the third rotating arm 1030 rotate, the first rotating member 910 may rotate. According to an embodiment, the second rotating member 920 may be connected to the second rotating arm 1020 and the fourth rotating arm 1040. For example, as the second rotating arm 1020 and the fourth rotating arm 1040 rotate, the second rotating member 920 may rotate.

According to an embodiment of the disclosure, the first rotating member 910 may be coupled to the first housing 310. For example, as the first rotating member 910 is rotated, the first housing 310 may rotate. According to an embodiment, the second rotating member 920 may be coupled to the second housing 320. For example, as the second rotating member 920 is rotated, the second housing 320 may rotate.

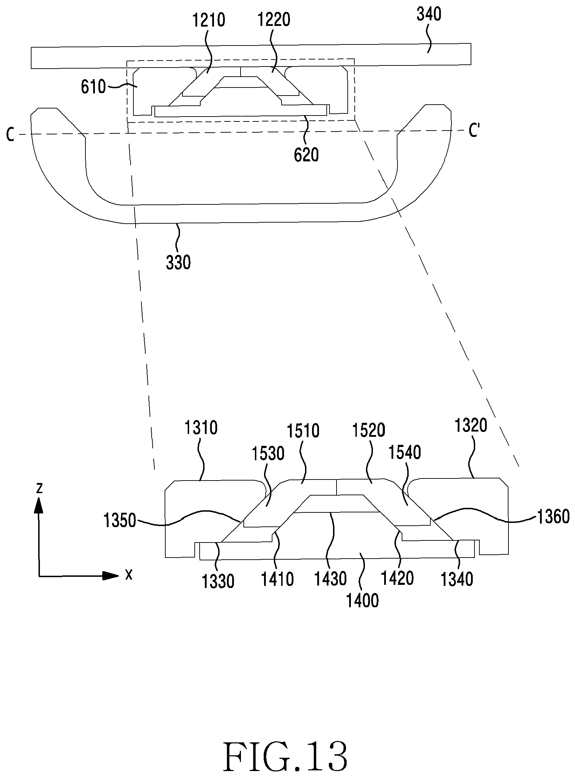

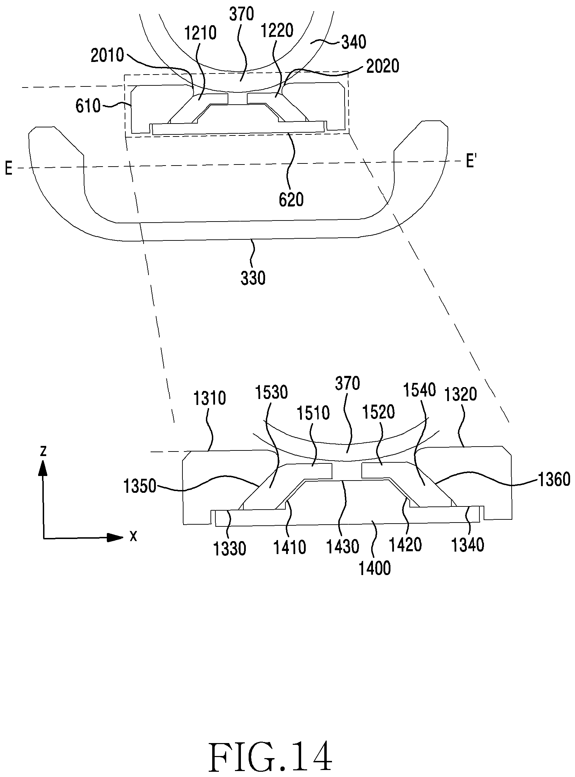

FIG. 13 is a cross-sectional view of a section C-C' of FIG. 11 according to an embodiment. FIG. 14 is a cross-sectional view of a section E-E' of FIG. 12 according to an embodiment.

According to an embodiment of the disclosure, the first fixing member 610 may include one side and the other side opposite to one side. According to an embodiment, one side and the other side of the first fixing member 610 may be formed by spacing apart from each other. For example, a space may be formed between one side and the other side of the first fixing member 610 to allow the first moving member 1210 and the second moving member 1220 to move. For example, one side and the other side of the first fixing member 610 may be connected to each other through an end formed with the first opening 710 and the second opening 720. For example, one side and the other side of the first fixing member 610 may be integrally formed, but may be spaced apart by a specific distance or more with the space formed in the center portion of the first fixing member 610.

According to an embodiment of the disclosure, one side of the first fixing member 610 may include a first top surface 1310, a first bottom surface 1330 and a first inclined surface 1350. For example, the first top surface 1310 may be a surface facing in the +z-axis direction. For example, the first bottom surface 1330 may be a surface opposite to the first top surface 1310 and facing in the -z-axis direction. For example, the first inclined surface 1350 may be a surface formed on at least a part of a side surface connecting the first top surface 1310 and the first bottom surface 1330. For example, the first inclined surface 1350 may be a surface inclined at a specific angle with respect to the first bottom surface 1330. For example, the first top surface 1310 may extend in a direction perpendicular to the first rotation axis 1110 and have a first width of a first length, the first bottom surface 1330 may extend in a direction perpendicular to the first rotation axis 1110 and have a second width which is shorter than the first length, and the first inclined surface 1350 may be formed to be inclined to connect the first top surface 1310 of the first width and the first bottom surface 1330 of the second width.

According to an embodiment of the disclosure, the other side of the first fixing member 610 may include a second top surface 1320, a second bottom surface 1340 and a second inclined surface 1360. For example, the second top surface 1320 may be a surface facing in the +z-axis direction. For example, the second bottom surface 1340 may be a surface opposite to the second top surface 1320 and facing in the -z-axis direction. For example, the second inclined surface 1360 may be a surface formed on at least a part of a side surface connecting the second top surface 1320 and the second bottom surface 1340. For example, the second inclined surface 1360 may be a surface inclined at a specific angle with respect to the second bottom surface 1340. For example, the second top surface 1320 may extend perpendicular to the second rotation axis 1120 and have a third width of a third length, the second bottom surface 1340 may extend in a direction perpendicular to the second rotation axis 1120 and have a fourth width which is shorter than the third length, and the second inclined surface 1360 may be formed to be inclined to connect the second top surface 1320 of the third width and the second bottom surface 1340 of the fourth width.

According to an embodiment of the disclosure, the first top surface 1310 and the second top surface 1320 may form the same plane. For example, a distance between the first bottom surface 1330 and the first top surface 1310 may be equal to a distance between the second top surface 1320 and the second bottom surface 1340. For example, the first bottom surface 1330 and the second bottom surface 1340 may form the same plane. According to an embodiment, an inclination direction of the first inclined surface 1350 may be opposite to an inclination direction of the second inclined surface 1360.

According to an embodiment of the disclosure, the second fixing member 620 may include an inclined portion 1400 formed on one side of the second fixing member 620 and the other side opposite to the one side. For example, the inclined portion 1400 may be a portion which protrudes a specific distance from the center portion of the second fixing member 620 toward the +z-axis direction. According to an embodiment, the inclined portion 1400 may include a third inclined surface 1410, a fourth inclined surface 1420 and a seating surface 1430. For example, the seating surface 1430 may be a surface extending from the third inclined surface 1410 and the fourth inclined surface 1420, and positioned between the third inclined surface 1410 and the fourth inclined surface 1420. For example, the seating surface 1430 may be a surface formed in the center portion of the inclined portion 1400. For example, the third inclined surface 1410 may be a surface formed on one side of the inclined portion 1400 and inclined at a specific angle. For example, the inclination direction of the third inclined surface 1410 may correspond to the inclination direction of the first inclined surface 1350 of one side of the first fixing member 610. For example, the fourth inclined surface 1420 may be a surface formed on the other side opposite to one side of the inclined portion 1400 and inclined at a specific angle. For example, the inclination direction of the fourth inclined surface 1420 may correspond to the inclination direction of the second inclined surface 1360 of the other side of the first fixing member 610.

According to an embodiment of the disclosure, the first bottom surface 1330 of one side of the first fixing member 610 may be disposed at least in part on one side of the second fixing member 620. According to an embodiment, the second bottom surface 1340 of the other side of the first fixing member 610 may be disposed at least in part on the other side of the second fixing member 620.

According to an embodiment of the disclosure, the moving member 520 may include the first moving member 1210 and the second moving member 1220. According to an embodiment, the first moving member 1210 and the second moving member 1220 may be configured to be movable within the space formed by the first fixing member 610 and the second fixing member 620. For example, the first moving member 1210 may be configured to be movable between the first inclined surface 1350 of one side of the first fixing member 610 and the third inclined surface 1410 of the inclined portion 1400 of the second fixing member 620. For example, the second moving member 1220 may be configured to be movable between the second inclined surface 1360 of the other side of the first fixing member 610 and the fourth inclined surface 1420 of the inclined portion 1400 of the second fixing member 620.

According to an embodiment of the disclosure, the first moving member 1210 may include a first flat portion 1510 and a first inclined portion 1530. For example, the first flat portion 1510 may be a portion extending in a direction perpendicular to the first rotation axis 1110 and formed in a flat shape. For example, the first flat portion 1510 may be a portion extending in a direction parallel to the seating surface 1430 of the inclined portion 1400. For example, the first inclined portion 1530 may be a portion extending from the first flat portion 1510 and formed to be inclined. For example, the first inclined portion 1530 may be a portion formed to correspond to the shape of the space formed between the first inclined surface 1350 of one side of the first fixing member 610 and the third inclined surface 1410 of the inclined portion 1400 of the second fixing member 620.

According to an embodiment of the disclosure, the second moving member 1220 may include a second flat portion 1520 and a second inclined portion 1540. For example, the second flat portion 1520 may be a portion extending in a direction perpendicular to the second rotation axis 1120 and formed in a flat shape. For example, the second flat portion 1520 may be a portion extending in a direction parallel to the seating surface 1430 of the inclined portion 1400. For example, the second inclined portion 1540 may be a portion extending from the second flat portion 1520 and formed to be inclined. For example, the second inclined portion 1540 may be a portion formed to correspond to the shape of the space formed between the second inclined surface 1360 of the other side of the first fixing member 610 and the fourth inclined surface 1420 of the inclined portion 1400 of the second fixing member 620.

According to an embodiment of the disclosure, referring to FIG. 13, in the unfolded state of the foldable electronic device 300, the first moving member 1210, the second moving member 1220 and the first fixing member 610 may support at least in part the flexible display 340. For example, one surface of the first moving member 1210, one surface of the second moving member 1220, and the first top surface 1310 and the second top surface 1320 of the first fixing member 610 may together support at least in part the flexible display 340. For example, one surface of the first moving member 1210, one surface of the second moving member 1220, and the first top surface 1310 and the second top surface 1320 of the first fixing member 610 may form the same plane to support the flexible display 340. The position of the first moving member 1210 and the second moving member 1220 shown in FIG. 13 may be referred to as the first position.

According to an embodiment of the disclosure, referring to FIG. 13, in the unfolded state of the foldable electronic device 300, the first moving member 1210 and the second moving member 1220 may ascend along the inclined portion 1400 of the second fixing member 620 to support the flexible display 340. For example, the first inclined portion 1530 of the first moving member 1210 may ascend along the third inclined surface 1410 of the inclined portion 1400 of the second fixing member 620. For example, with the first inclined portion 1530 of the first moving member 1210 contacting the third inclined surface 1410 of the inclined portion 1400 of the second fixing member 620, the first moving member 1210 may ascend as the first moving member 1210 slides along the third inclined surface 1410.

According to an embodiment of the disclosure, referring to FIG. 13, for example, the second inclined portion 1540 of the second moving member 1220 may ascend along the fourth inclined surface 1420 of the inclined portion 1400 of the second fixing member 620. For example, with the second inclined portion 1540 of the second moving member 1220 contacting the fourth inclined surface 1420 of the inclined portion 1400 of the second fixing member 620, the second moving member 1220 may ascend as the second moving member 1220 slides along the fourth inclined surface 1420.

According to an embodiment of the disclosure, referring to FIG. 13, as the first moving member 1210 and the second moving member 1220 ascend, the first moving member 1210 and the second moving member 1220 may move close to each other. For example, as the first moving member 1210 and the second moving member 1220 ascend, the first flat portion 1510 of the first moving member 1210 and the second flat portion 1520 of the second moving member 1220 may move close to each other. For example, as the first moving member 1210 and the second moving member 1220 ascend, a side surface facing in the +x-axis direction of the first flat portion 1510 and a side surface facing in the -x-axis direction of the second flat portion 1520 may move closer. For example, in the unfolded state of the foldable electronic device 300, the side surface of the first flat portion 1510 and the side surface of the second flat portion 1520 may be contacted.

According to an embodiment of the disclosure, referring to FIG. 14, while the foldable electronic device 300 is folded, the first moving member 1210 and the second moving member 1220 may be configured to move within the space formed by the first fixing member 610 and the second fixing member 620 not to interfere with the folding portion 370 of the flexible display 340. For example, as the foldable electronic device 300 is folded, the folding portion 370 of the flexible display 340 may sag in the -z-axis direction, and the first moving member 1210 and the second moving member 1220 may be lowered not to interfere with the folding portion 370 sagging toward the -z-axis direction. The position of the first moving member 1210 and the second moving member 1220 shown in FIG. 14 may be referred to as the second position.

According to an embodiment of the disclosure, Referring to FIG. 14, while the foldable electronic device 300 is folded, the first moving member 1210 and the second moving member 1220 may be moved away from each other. For example, the first flat portion 1510 of the first moving member 1210 and the second flat portion 1520 of the second moving member 1220 may move away from each other. For example, a side surface of the first flat portion 1510 and a side surface of the second flat portion 1520 facing the side surface of the first flat portion 1510 may move away from each other. For example, the first flat portion 1510 may be moved in the -x-axis direction perpendicular to the first rotation axis 1110, and the second flat portion 1520 may be moved in the +x-axis direction perpendicular to the second rotation axis 1120.

According to an embodiment of the disclosure, referring to FIG. 14, while the foldable electronic device 300 is folded, with the side surface of the first flat portion 1510 and the side surface of the second flat portion 1520 spaced apart by a specific distance, the first moving member 1210 and the second moving member 1220 may be configured to descend. For example, the first inclined portion 1530 of the first moving member 1210 may be configured to descend within a space between the first inclined surface 1350 of one side of the first fixing member 610 and the third inclined surface 1410 of the inclined portion 1400 of the second fixing member 620. For example, the first inclined portion 1530 of the first moving member 1210 may be configured to slide in contact with the first inclined surface 1350 of one side of the first fixing member 610 and/or the third inclined surface 1410 of the second fixing member 620. For example, as the first inclined portion 1530 of the first moving member 1210 slides along the third inclined surface 1410 of the second fixing member 620, the first moving member 1210 may be configured to descend.

According to an embodiment of the disclosure, referring to FIG. 14, for example, the second inclined portion 1540 of the second moving member 1220 may be configured to descend within a space between the second inclined surface 1360 of the other side of the first fixing member 610 and the fourth inclined surface 1420 of the inclined portion 1400 of the second fixing member 620. For example, the second inclined portion 1540 of the second moving member 1220 may be configured to slide in contact with the second inclined surface 1360 of the other side of the first fixing member 610 and/or the fourth inclined surface 1420 of the second fixing member 620. For example, as the second inclined portion 1540 of the second moving member 1220 slides along the fourth inclined surface 1420 of the second fixing member 620, the second moving member 1220 may be configured to descend.

According to an embodiment of the disclosure, referring to FIG. 14, in the folded state of the foldable electronic device 300, one side of the first moving member 1210 and the first fixing member 610 may form a step. For example, one surface facing in the +z-axis direction of the first flat portion 1510 of the first moving member 1210 and the first top surface 1310 of one side of the first fixing member 610 may form the step. According to an embodiment, in the folded state of the foldable electronic device 300, the second moving member 1220 and the other side of the first fixing member 610 may form a step. For example, one surface facing in the +z-axis direction of the second flat portion 1520 of the second moving member 1220 and the second top surface 1320 of the other side of the first fixing member 610 may form the step.

According to an embodiment of the disclosure, referring to FIG. 14, in the folded state of the foldable electronic device 300, a side surface facing in the +x direction of one side of the first fixing member 610, one surface facing in the +z axis direction of the first moving member 1210, one surface facing in the +z axis direction of the second moving member 1220, and a side surface facing in the -x axis direction of the other side of the first fixing member 610 may form a recess. According to an embodiment, the flexible display 340 may be disposed at least in part within the recess. For example, the folding portion 370 of the flexible display 340 may be disposed at least in part within the recess.

According to an embodiment of the disclosure, referring to FIG. 14, in the folded state of the foldable electronic device 300, the first moving member 1210 and the second moving member 1220 may be seated on the inclined portion 1400 of the second fixing member 620. For example, the bottom surface facing in the -z-axis of the first flat portion 1510 of the first moving member 1210 may be seated on the seating surface 1430 of the inclined portion 1400 of the second fixing member 620. For example, the bottom surface facing in the -z-axis of the second flat portion 1520 of the second moving member 1220 may be seated on the seating surface 1430 of the inclined portion 1400 of the second fixing member 620.

According to an embodiment of the disclosure, referring to FIG. 14, in the folded state of the foldable electronic device 300, one end of the first inclined portion 1530 of the first moving member 1210 may be disposed on one side of the second fixing member 620. According to an embodiment, in the folded state of the foldable electronic device 300, one end of the second inclined portion 1540 of the second moving member 1220 may be disposed on the other side of the second fixing member 620.

According to an embodiment of the disclosure, referring to FIG. 14, the first fixing member 610 may include a first curved portion 2010. For example, the first curved portion 2010 may be formed at one end of the first top surface 1310 of the first fixing member 610. For example, the first curved portion 2010 may be formed at least in part between the first top surface 1310 of the first fixing member 610 and a side surface extending from the first top surface 1310. For example, the first curved portion 2010 may be formed to have a specific curvature. According to an embodiment, referring to FIG. 14, the second fixing member 620 may include a second curved portion 2020. For example, the second curved portion 2020 may be formed at one end of the second top surface 1320 of the second fixing member 620. For example, the second curved portion 2020 may be formed at least in part between the second top surface 1320 of the second fixing member 620 and a side surface extending from the second top surface 1320. For example, the first curved portion 2010 may be formed to have a specific curvature. According to an embodiment, the first curved portion 2010 and the second curved portion 2020 may be formed to face each other.

According to an embodiment of the disclosure, in the folded state of the foldable electronic device 300, the first curved portion 2010 of the first fixing member 610 may be formed at a position facing one side of the folding portion 370 of the flexible display 340. According to an embodiment, in the folded state of the foldable electronic device 300, the second curved portion 2020 of the second fixing member 620 may be formed at a position facing the other side of the folding portion 370 of the flexible display 340.

According to an embodiment of the disclosure, thanks to the first curved portion 2010 of the first fixing member 610 and the second curved portion 2020 of the second fixing member 620, if an impact is applied to the foldable electronic device 300 in the folded state of the foldable electronic device 300, the folding portion 370 of the flexible display 340 may not collide with the first fixing member 610 and the second fixing member 620.

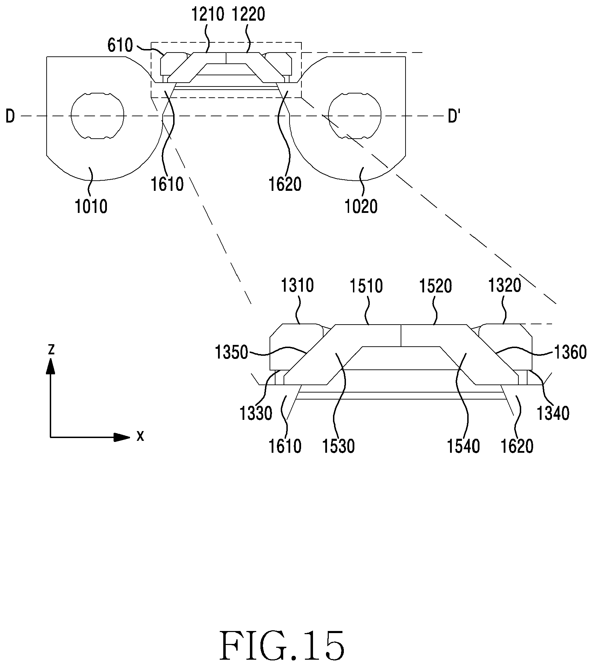

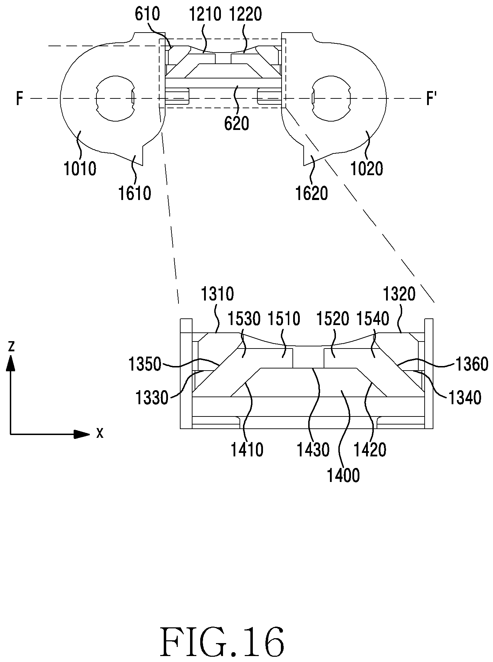

FIG. 15 is a cross-sectional view of a section D-D' of FIG. 11 according to an embodiment. FIG. 16 is a cross-sectional view of a section F-F' of FIG. 12 according to an embodiment.

According to an embodiment of the disclosure, the first rotating arm 1010 may include a first protrusion 1610. According to an embodiment, referring to FIG. 15, while the foldable electronic device 300 is unfolded, the first protrusion 1610 of the first rotating arm 1010 may lift the first moving member 1210. For example, while the foldable electronic device 300 is unfolded, the first protrusion 1610 of the first rotating arm 1010 may lift the first inclined portion 1530 of the first moving member 1210. For example, as the first inclined portion 1530 of the first moving member 1210 is lifted by the first protrusion 1610 of the first rotating arm 1010, the first inclined portion 1530 may ascend along the first inclined surface 1350 of one side of the first fixing member 610 and/or the third inclined surface 1410 of the inclined portion 1400 of the second fixing member 620. For example, as the first inclined portion 1530 is lifted, the first moving member 1210 may ascend.

According to an embodiment of the disclosure, the second rotating arm 1020 may include a second protrusion 1620. According to an embodiment, referring to FIG. 15, while the foldable electronic device 300 is unfolded, the second protrusion 1620 of the second rotating arm 1020 may lift the second moving member 1220. For example, while the foldable electronic device 300 is unfolded, the second protrusion 1620 of the second rotating arm 1020 may lift the second inclined portion 1540 of the second moving member 1220. For example, as the second inclined portion 1540 of the second moving member 1220 is lifted by the second protrusion 1620 of the second rotating arm 1020, the second inclined portion 1540 may ascend along the second inclined surface 1360 of the other side of the first fixing member 610 and/or the fourth inclined surface 1420 of the inclined portion 1400 of the second fixing member 620. For example, as the second inclined portion 1540 is lifted, the second moving member 1220 may ascend.

According to an embodiment of the disclosure, as the foldable electronic device 300 is unfolded, as the first moving member 1210 is lifted by the first rotating arm 1010 and the second moving member 1220 is lifted by the second rotating arm 1020, a side surface facing in the +x-axis direction of the first moving member 1210 and a side surface facing in the -x-axis direction of the second moving member 1220 may move close to each other. For example, in the unfolded state of the foldable electronic device 300, the side surface of the first moving member 1210 and the side surface of the second moving member 1220 may be contacted.

According to an embodiment of the disclosure, referring to FIG. 15, in the unfolded state of the foldable electronic device 300, the first rotating arm 1010 may support the first moving member 1210 to block the first moving member 1210 from descending. For example, the first protrusion 1610 of the first rotating arm 1010 may support one end of the first inclined portion 1530 of the first moving member 1210. According to an embodiment, in the unfolded state of the foldable electronic device 300, the second rotating arm 1020 may support the second moving member 1220 to prevent the second moving member 1220 from descending. For example, the second protrusion 1620 of the second rotating arm 1020 may support one end of the second inclined portion 1540 of the second moving member 1220.

According to an embodiment of the disclosure, referring to FIG. 15, in the unfolded state of the foldable electronic device 300, as the first moving member 1210 and the second moving member 1220 are supported by the first rotating arm 1010 and the second rotating arm 1020, the first moving member 1210 and the second moving member 1220 may flatly support the folding portion 370 of the flexible display 340 without descending.

According to an embodiment of the disclosure, referring to FIG. 16, while the foldable electronic device 300 is folded, the first protrusion 1610 may rotate together with the first rotating arm 1010. As the first protrusion 1610 is rotated, the first moving member 1210 may not be supported by the first protrusion 1610. For example, as the first moving member 1210 is not supported by the first protrusion 1610, the first moving member 1210 may descend. According to an embodiment, while the foldable electronic device 300 is folded, the second protrusion 1620 may rotate together with the second rotating arm 1020. As the second protrusion 1620 is rotated, the second moving member 1220 may not be supported by the second protrusion 1620. For example, as the second moving member 1220 is not supported by the second protrusion 1620, the second moving member 1220 may descend.

According to an embodiment of the disclosure, referring to FIG. 16, as the first moving member 1210 is not supported by the first protrusion 1610 and the second moving member 1220 is not supported by the second protrusion 1620, the first flat portion 1510 of the first moving member 1210 and the second flat portion 1520 of the second moving member 1220 may move away from each other along a direction perpendicular to the first rotation axis 1110 and the second rotation axis 1120. For example, as the first moving member 1210 is not supported by the first protrusion 1610 and the second moving member 1220 is not supported by the second protrusion 1620, the first moving member 1210 and the second moving member 1220 may be moved in a direction such that a side surface facing in the +x-axis direction of the first flat portion 1510 of the first moving member 1210 and a side surface facing in the -x-axis direction of the second flat portion 1520 of the second moving member 1220 move away from each other.

According to an embodiment of the disclosure, referring to FIG. 16, while the foldable electronic device 300 is folded, if the first flat portion 1510 of the first moving member 1210 and the second flat portion 1520 of the second moving member 1220 are moved away from each other, the first inclined portion 1530 of the first moving member 1210 may slide along the third inclined surface 1410 of the second fixing member 620 and the second inclined portion 1540 of the second moving member 1220 may slide along the fourth inclined surface 1420 of the second fixing member 620. For example, as the first inclined portion 1530 of the first moving member 1210 slides along the third inclined surface 1410 of the second fixing member 620 and the second inclined portion 1540 of the second moving member 1220 slides along the fourth inclined surface 1420 of the second fixing member 620, the first moving member 1210 and the second moving member 1220 may descend.

FIG. 17 is a cross-sectional view of a section G-G' of FIG. 11 according to an embodiment. FIG. 18 is a cross-sectional view of a section H-H' of FIG. 12 according to an embodiment.

According to an embodiment of the disclosure, the foldable electronic device 300 may further include an elastic member 1720. For example, referring to FIG. 17, the elastic member 1720 may be disposed in a top portion and/or a bottom portion of the supporting assembly 420, but is not limited thereto. For example, the elastic member 1720 may be disposed between the first moving member 1210 and the second moving member 1220 of the supporting assembly 420.

According to an embodiment of the disclosure, referring to FIG. 17, a recess 1710 may be formed in the first moving member 1210 and/or the second moving member 1220. For example, the recess 1710 may be concavely formed in a direction perpendicular to the first rotation axis 1110 and the second rotation axis 1120. For example, referring to FIG. 17, the recess 1710 may be concavely formed toward the -x-axis direction in the top portion of the first moving member 1210. For example, the recess 1710 may be concavely formed toward the +x-axis direction in the bottom portion of the second moving member 1220. According to an embodiment, the elastic member 1720 may be disposed within the recess 1710. For example, the elastic member 1720 may be disposed within the recess 1710 formed in the top portion of the first moving member 1210. For example, the elastic member 1720 may be disposed within the recess 1710 formed in the bottom portion of the second moving member 1220.

According to an embodiment of the disclosure, referring to the cross-section G-G' of FIG. 17, in the unfolded state of the foldable electronic device 300, the elastic member 1720 may be disposed between the recess 1710 of the first moving member 1210 and the side surface of the second moving member 1220. For example, in the unfolded state of the foldable electronic device 300, as the side surface of the first moving member 1210 and the side surface of the second moving member 1220 are positioned to face each other, the elastic member 1720 may be disposed in a compressed state between the recess 1710 of the first moving member 1210 and the side surface of the second moving member 1220.

According to an embodiment of the disclosure, referring to FIG. 17, in the unfolded state of the foldable electronic device 300, the compressed elastic member 1720 may exert an elastic force on the first moving member 1210 and the second moving member 1220 in a direction perpendicular to the first rotation axis 1110 and the second rotation axis 1120. For example, in the unfolded state of the foldable electronic device 300, the elastic member 1720 may exert the elastic force on the first moving member 1210 in the -x-axis direction. For example, in the unfolded state of the foldable electronic device 300, the elastic member 1720 may apply the elastic force to the second moving member 1220 in the +x-axis direction.

According to an embodiment of the disclosure, referring to FIG. 17, in the unfolded state of the foldable electronic device 300, even if the elastic member 1720 applies the elastic force to the first moving member 1210 and the second moving member 1220, the first moving member 1210 and the second moving member 1220, which are supported by the first rotating arm 1010 and the second rotating arm 1020 respectively, may not move in the direction perpendicular to the first rotation axis 1110 and the second rotation axis 1120. Since the first moving member 1210 and the second moving member 1220 are not moved, the first moving member 1210 and the second moving member 1220 may not descend.

According to an embodiment of the disclosure, referring to FIG. 18, while the foldable electronic device 300 is folded, since the first rotating arm 1010 and the second rotating arm 1020 are rotated and the first moving member 1210 and the second moving member 1220 are not supported by the first rotating arm 1010 and the second rotating arm 1020 respectively, the first moving member 1210 and the second moving member 1220 may be moved by the elastic force of the elastic member 1720. For example, the first moving member 1210 may be moved in the -x-axis direction by the elastic force of the elastic member 1720. For example, the second moving member 1220 may be moved in the +x-axis direction by the elastic force of the elastic member 1720. For example, the side surface of the first moving member 1210 and the side surface of the second moving member 1220 may be moved away by the elastic force of the elastic member 1720.

According to an embodiment of the disclosure, referring to FIG. 18, as the first moving member 1210 and the second moving member 1220 are moved in a direction perpendicular to the first rotation axis 1110 and the second rotation axis 1120 by the elastic force of the elastic member 1720, the elastic member 1720 may be restored to its pre-compression shape. For example, the elastic member 1720 restored to its pre-compression shape may be positioned between the recess 1710 of the first moving member 1210 and the side surface of the second moving member 1220.

According to an embodiment of the disclosure, referring to FIG. 18, the first moving member 1210 and the second moving member 1220 moved along the x-axis direction by the elastic member 1720 may descend. For example, as the first inclined portion 1530 slides along the third inclined surface 1410 of the second fixing member 620, the first moving member 1210 may descend. For example, as the second inclined portion 1540 slides along the fourth inclined surface 1420 of the second fixing member 620, the second moving member 1220 may descend.

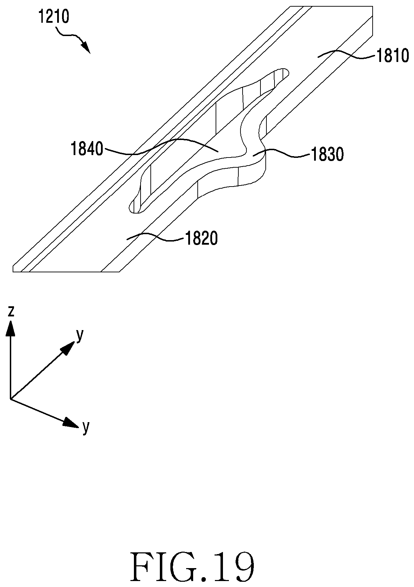

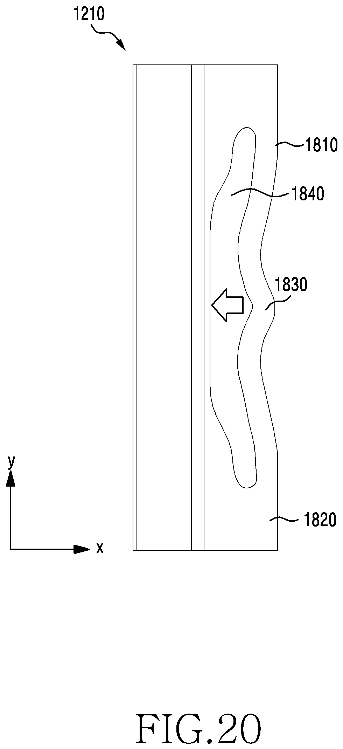

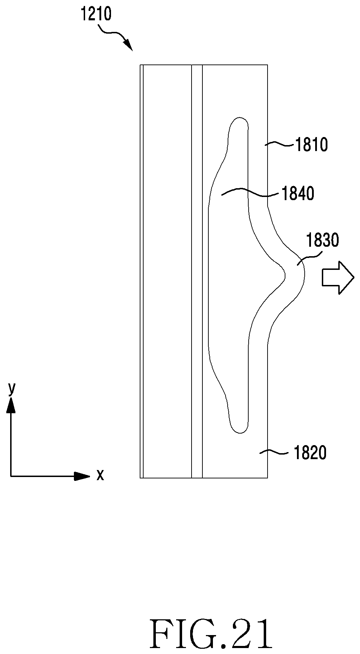

FIG. 19 is a perspective view of a first moving member formed of an elastic material according to an embodiment. FIG. 20 is a front view of a first moving member formed of an elastic material in an unfolded state of a foldable electronic device according to an embodiment. FIG. 21 is a front view of a first moving member formed of an elastic material in a folded state of a foldable electronic device according to an embodiment.

According to an embodiment of the disclosure, only the first moving member 1210 is shown in FIG. 19 through FIG. 21, but the second moving member 1220 may be formed in the same shape as the first moving member 1210 of FIG. 19 through FIG. 21.

According to an embodiment of the disclosure, the first moving member 1210 may be formed of an elastic material. According to an embodiment, the first moving member 1210 may include a top portion 1810, a bottom portion 1820, and a protrusion 1830 formed between the top portion 1810 and the bottom portion 1820. For example, the top portion 1810 and the bottom portion 1820 of the first moving member 1210 may be portions extending from the protrusion 1830 in a direction parallel to the first rotation axis 1110 and the second rotation axis 1120. For example, the top portion 1810 and the bottom portion 1820 of the first moving member 1210 may be portions extending in the y-axis direction. For example, the top portion 1810 and the bottom portion 1820 of the first moving member 1210 may be portions extending in a longitudinal direction of the first moving member 1210. For example, the protrusion 1830 may be formed at a position where the elastic member 1720 of FIG. 17 and FIG. 18 is disposed. For example, the protrusion 1830 may be formed on a side surface of one side of the first moving member 1210. For example, one side of the first moving member 1210 may be a portion adjacent to the second moving member 1220. For example, the side surface of one side of the first moving member 1210 may be a surface facing in the +x-axis direction and opposite to the side surface of one side of the second moving member 1220.

According to an embodiment of the disclosure, the first moving member 1210 may include an opening 1840. For example, the opening 1840 may be formed between one side of the first moving member 1210 and the other side opposite to one side. For example, the opening 1840 may be formed to penetrate one surface facing in the +x-axis direction of the first moving member 1210 and the other surface opposite to the sone surface. For example, the opening 1840 may be formed between the protrusion 1830 and the other side of the first moving member 1210.

According to an embodiment of the disclosure, referring to FIG. 20, for example, as the foldable electronic device 300 is unfolded, the protrusion 1830 of the first moving member 1210 may contact a side surface of one side of the second moving member 1220. For example, as the foldable electronic device 300 is unfolded, the protrusion 1830 of the first moving member 1210 may be compressed by the side surface of one side of the second moving member 1220. For example, as the protrusion 1830 of the first moving member 1210 is compressed, the protrusion 1830 may be moved in the -x-axis direction. For example, as the protrusion 1830 is moved in the -x-axis direction, the protrusion 1830 may be positioned at the position of the opening 1840.

According to an embodiment of the disclosure, referring to FIG. 20, as the first moving member 1210 and the second moving member 1220 contact, the compressed protrusion 1830 may exert the elastic force on the first moving member 1210 and the second moving member 1220. For example, in the unfolded state of the foldable electronic device 300, the protrusion 1830 may exert the elastic force on the first moving member 1210 in the -x-axis direction, and the elastic force on the second moving member 1220 in the +x-axis direction.

According to an embodiment of the disclosure, referring to FIG. 21, while the foldable electronic device 300 is folded, the protrusion 1830 may be restored to a pre-compressed position. For example, while the foldable electronic device 300 is folded, as the protrusion 1830 is restored, the protrusion 1830 may push the second moving member 1220. For example, the first moving member 1210 may be moved in a direction away from the second moving member 1220 by the repulsive force of the protrusion 1830 pushing the second moving member 1220.

According to an embodiment of the disclosure, referring to FIG. 19 through FIG. 21, in the folded state of the foldable electronic device 300, the first moving member 1210 and the second moving member 1220 may be moved apart by the protrusion 1830 of the first moving member 1210. According to an embodiment, in the unfolded state of the foldable electronic device 300, the first moving member 1210 and the second moving member 1220 may be moved closer to each other by the first rotating arm 1010 and the second rotating arm 1020.

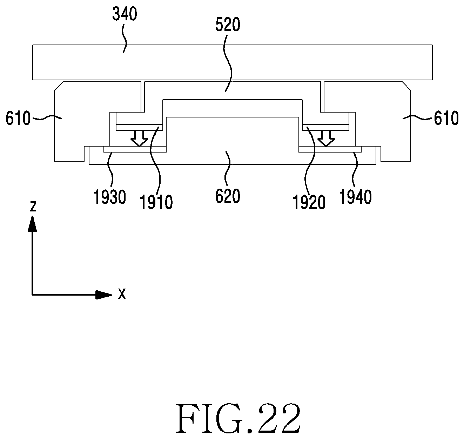

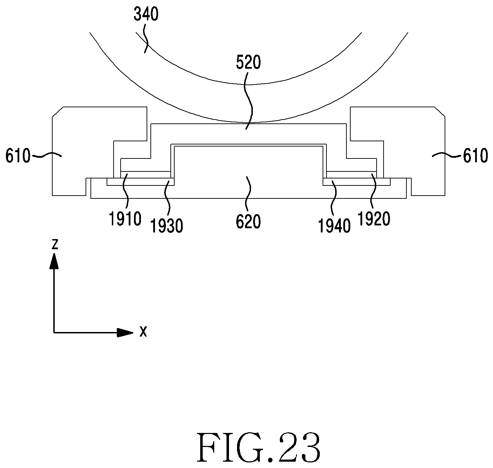

FIG. 22 is a view illustrating an unfolded state of a foldable electronic device including a magnetic body according to an embodiment. FIG. 23 is a view illustrating a folded state of a foldable electronic device including a magnetic body according to an embodiment.

According to an embodiment of the disclosure, referring to FIG. 22, the moving member 520 may include a first magnetic body 1910 (e.g., a first magnet) and a second magnetic body 1920 (e.g., a second magnet). For example, the first magnetic body 1910 may be disposed on one side of the moving member 520. For example, the first magnetic body 1910 may be attached to one surface facing in the -z-axis direction in an end of one side of the moving member 520. For example, the second magnetic body 1920 may be disposed on the other side opposite to one side of the moving member 520. For example, the second magnetic body 1920 may be attached to one surface facing in the -z-axis direction of an end of the other side of the moving member 520.

According to an embodiment of the disclosure, referring to FIG. 22, the second fixing member 620 may include a third magnetic body 1930 (e.g., a third magnet) and a fourth magnetic body 1940 (e.g., a fourth magnet). For example, the third magnetic body 1930 may be disposed on one side of the second fixing member 620. For example, the third magnet body 1930 may be disposed on one side of one surface of the second fixing member 620 facing in the +z-axis direction. For example, the fourth magnetic element 1940 may be disposed on the other side opposite to one side of one surface facing in the +z-axis direction of the second fixing member 620.

According to an embodiment of the disclosure, referring to FIG. 22 and FIG. 23, the third magnetic body 1930 may be disposed at a position corresponding to the first magnetic body 1910. For example, the third magnetic body 1930 and the first magnetic body 1910 may be disposed to face each other. According to an embodiment, the fourth magnetic body 1940 may be disposed at a position corresponding to the second magnetic body 1920. For example, the fourth magnetic body 1940 and the second magnetic body 1920 may be disposed to face each other.

According to an embodiment of the disclosure, the third magnetic body 1930 may be formed to have a polarity opposite to a polarity of the first magnetic body 1910. For example, if a distance between the first magnetic body 1910 and the third magnetic body 1930 falls within a specific distance, attraction may occur between the first magnetic body 1910 and the third magnetic body 1930 such that the first magnetic body 1910 approaches the third magnetic body 1930. For example, the first magnetic body 1910 may attached onto the third magnetic body 1930 by the attraction between the first magnetic body 1910 and the third magnetic body 1930. According to an embodiment, the fourth magnetic body 1940 may be formed to have a polarity opposite to a polarity of the second magnetic body 1920. For example, if a distance between the second magnetic body 1920 and the fourth magnetic body 1940 falls within a specific distance, attraction may occur between the second magnetic body 1920 and the fourth magnetic body 1940 such that the second magnetic body 1920 approaches the fourth magnetic body 1940. For example, the second magnetic body 1920 may be attached to the fourth magnetic body 1940 by the attraction between the second magnetic body 1920 and the fourth magnetic body 1940.

According to an embodiment of the disclosure, referring to FIG. 22, the moving member 520 may be configured to move within the space between the first fixing member 610 and the second fixing member 620. For example, the moving member 520 may be configured to ascend or descend within the space between the first fixing member 610 and the second fixing member 620. For example, the shape of the space formed by the first fixing member 610 and the second fixing member 620 may be formed to correspond to the shape of the moving member 520. The position of the moving member 520 shown in FIG. 22 may be referred to as the first position.

According to an embodiment of the disclosure, referring to FIG. 22, the moving member 520 may be lifted in the unfolded state of the foldable electronic device 300, and the first fixing member 610 and the moving member 520 may support the flexible display 340. For example, in the unfolded state of the foldable electronic device 300, the moving member 520 may support the folding portion 370 of the flexible display 340, and the first fixing member 610 may support the flat portion 360 of the flexible display 340.

According to an embodiment of the disclosure, referring to FIG. 23, while the foldable electronic device 300 is folded, the moving member 520 may be descended and positioned on the second fixing member 620. For example, while the foldable electronic device 300 is folded, the moving member 520 may be more firmly seated on the second fixing member 620 by the attraction between the first magnetic body 1910 and the third magnetic body 1930 and the attraction between the second magnetic body 1920 and the fourth magnetic body 1940. The position of the moving member 520 shown in FIG. 23 may be referred to as the second position.

According to an embodiment of the disclosure, referring to FIG. 23, while the foldable electronic device 300 is folded, one surface facing in the +z-axis direction of the moving member 520 may form a step with one surface facing in the +z-axis direction of the first fixing member 610. According to an embodiment, in the folded state of the foldable electronic device 300, a side surface extending from the one surface of the first fixing member 610 and perpendicular to the one surface and one surface of the moving member 520 may form a recess. According to an embodiment, the folding portion 370 of the flexible display 340 may be disposed within the recess.

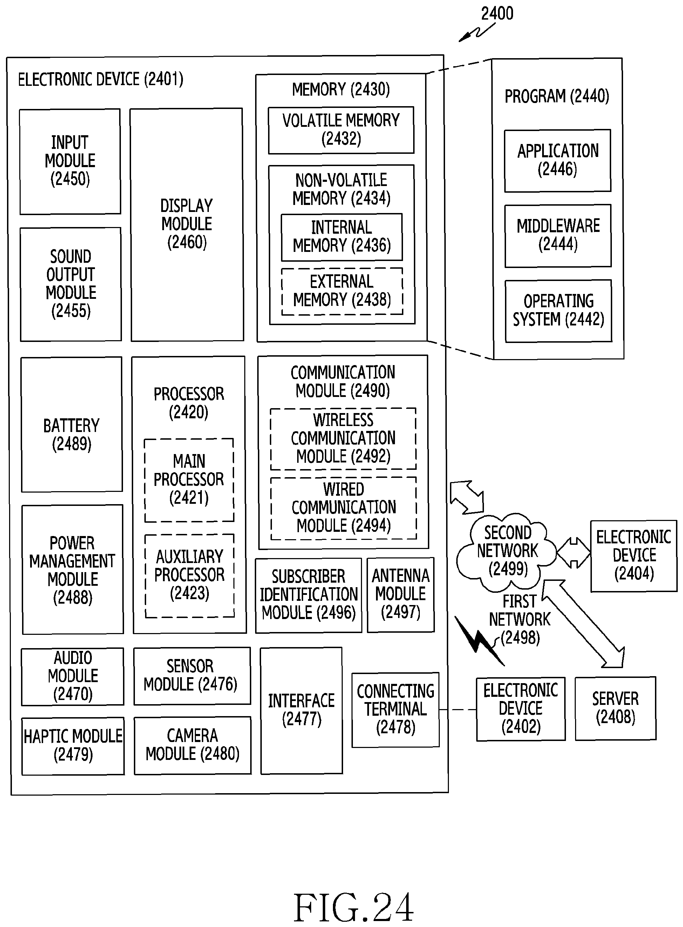

Fig. 24 is a block diagram illustrating an electronic device 2401 in a network environment 2400 according to various embodiments. Referring to Fig. 24, the electronic device 2401 in the network environment 2400 may communicate with an electronic device 2402 via a first network 2498 (e.g., a short-range wireless communication network), or at least one of an electronic device 2404 or a server 2408 via a second network 2499 (e.g., a long-range wireless communication network). According to an embodiment, the electronic device 2401 may communicate with the electronic device 2404 via the server 2408. According to an embodiment, the electronic device 2401 may include a processor 2420, memory 2430, an input module 2450, a sound output module 2455, a display module 2460, an audio module 2470, a sensor module 2476, an interface 2477, a connecting terminal 2478, a haptic module 2479, a camera module 2480, a power management module 2488, a battery 2489, a communication module 2490, a subscriber identification module(SIM) 2496, or an antenna module 2497. In some embodiments, at least one of the components (e.g., the connecting terminal 2478) may be omitted from the electronic device 2401, or one or more other components may be added in the electronic device 2401. In some embodiments, some of the components (e.g., the sensor module 2476, the camera module 2480, or the antenna module 2497) may be implemented as a single component (e.g., the display module 2460).

The processor 2420 may execute, for example, software (e.g., a program 2440) to control at least one other component (e.g., a hardware or software component) of the electronic device 2401 coupled with the processor 2420, and may perform various data processing or computation. According to one embodiment, as at least part of the data processing or computation, the processor 2420 may store a command or data received from another component (e.g., the sensor module 2476 or the communication module 2490) in volatile memory 2432, process the command or the data stored in the volatile memory 2432, and store resulting data in non-volatile memory 2434. According to an embodiment, the processor 2420 may include a main processor 2421 (e.g., a central processing unit (CPU) or an application processor (AP)), or an auxiliary processor 2423 (e.g., a graphics processing unit (GPU), a neural processing unit (NPU), an image signal processor (ISP), a sensor hub processor, or a communication processor (CP)) that is operable independently from, or in conjunction with, the main processor 2421. For example, when the electronic device 2401 includes the main processor 2421 and the auxiliary processor 2423, the auxiliary processor 2423 may be adapted to consume less power than the main processor 2421, or to be specific to a specified function. The auxiliary processor 2423 may be implemented as separate from, or as part of the main processor 2421.

The auxiliary processor 2423 may control at least some of functions or states related to at least one component (e.g., the display module 2460, the sensor module 2476, or the communication module 2490) among the components of the electronic device 2401, instead of the main processor 2421 while the main processor 2421 is in an inactive (e.g., sleep) state, or together with the main processor 2421 while the main processor 2421 is in an active state (e.g., executing an application). According to an embodiment, the auxiliary processor 2423 (e.g., an image signal processor or a communication processor) may be implemented as part of another component (e.g., the camera module 2480 or the communication module 2490) functionally related to the auxiliary processor 2423. According to an embodiment, the auxiliary processor 2423 (e.g., the neural processing unit) may include a hardware structure specified for artificial intelligence model processing. An artificial intelligence model may be generated by machine learning. Such learning may be performed, e.g., by the electronic device 2401 where the artificial intelligence is performed or via a separate server (e.g., the server 2408). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 2430 may store various data used by at least one component (e.g., the processor 2420 or the sensor module 2476) of the electronic device 2401. The various data may include, for example, software (e.g., the program 2440) and input data or output data for a command related thererto. The memory 2430 may include the volatile memory 2432 or the non-volatile memory 2434.

The program 2440 may be stored in the memory 2430 as software, and may include, for example, an operating system (OS) 2442, middleware 2444, or an application 2446.

The input module 2450 may receive a command or data to be used by another component (e.g., the processor 2420) of the electronic device 2401, from the outside (e.g., a user) of the electronic device 2401. The input module 2450 may include, for example, a microphone, a mouse, a keyboard, a key (e.g., a button), or a digital pen (e.g., a stylus pen).

The sound output module 2455 may output sound signals to the outside of the electronic device 2401. The sound output module 2455 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 2460 may visually provide information to the outside (e.g., a user) of the electronic device 2401. The display module 2460 may include, for example, a display, a hologram device, or a projector and control circuitry to control a corresponding one of the display, hologram device, and projector. According to an embodiment, the display module 2460 may include a touch sensor adapted to detect a touch, or a pressure sensor adapted to measure the intensity of force incurred by the touch.

The audio module 2470 may convert a sound into an electrical signal and vice versa. According to an embodiment, the audio module 2470 may obtain the sound via the input module 2450, or output the sound via the sound output module 2455 or a headphone of an external electronic device (e.g., an electronic device 2402) directly (e.g., wiredly) or wirelessly coupled with the electronic device 2401.

The sensor module 2476 may detect an operational state (e.g., power or temperature) of the electronic device 2401 or an environmental state (e.g., a state of a user) external to the electronic device 2401, and then generate an electrical signal or data value corresponding to the detected state. According to an embodiment, the sensor module 2476 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 2477 may support one or more specified protocols to be used for the electronic device 2401 to be coupled with the external electronic device (e.g., the electronic device 2402) directly (e.g., wiredly) or wirelessly. According to an embodiment, the interface 2477 may include, for example, a high definition multimedia interface (HDMI), a universal serial bus (USB) interface, a secure digital (SD) card interface, or an audio interface.

A connecting terminal 2478 may include a connector via which the electronic device 2401 may be physically connected with the external electronic device (e.g., the electronic device 2402). According to an embodiment, the connecting terminal 2478 may include, for example, a HDMI connector, a USB connector, a SD card connector, or an audio connector (e.g., a headphone connector).

The haptic module 2479 may convert an electrical signal into a mechanical stimulus (e.g., a vibration or a movement) or electrical stimulus which may be recognized by a user via his tactile sensation or kinesthetic sensation. According to an embodiment, the haptic module 2479 may include, for example, a motor, a piezoelectric element, or an electric stimulator.

The camera module 2480 may capture a still image or moving images. According to an embodiment, the camera module 2480 may include one or more lenses, image sensors, image signal processors, or flashes.

The power management module 2488 may manage power supplied to the electronic device 2401. According to one embodiment, the power management module 2488 may be implemented as at least part of, for example, a power management integrated circuit (PMIC).

The battery 2489 may supply power to at least one component of the electronic device 2401. According to an embodiment, the battery 2489 may include, for example, a primary cell which is not rechargeable, a secondary cell which is rechargeable, or a fuel cell.

The communication module 2490 may support establishing a direct (e.g., wired) communication channel or a wireless communication channel between the electronic device 2401 and the external electronic device (e.g., the electronic device 2402, the electronic device 2404, or the server 2408) and performing communication via the established communication channel. The communication module 2490 may include one or more communication processors that are operable independently from the processor 2420 (e.g., the application processor (AP)) and supports a direct (e.g., wired) communication or a wireless communication. According to an embodiment, the communication module 2490 may include a wireless communication module 2492 (e.g., a cellular communication module, a short-range wireless communication module, or a global navigation satellite system (GNSS) communication module) or a wired communication module 2494 (e.g., a local area network (LAN) communication module or a power line communication (PLC) module). A corresponding one of these communication modules may communicate with the external electronic device via the first network 2498 (e.g., a short-range communication network, such as BluetoothTM, wireless-fidelity (Wi-Fi) direct, or infrared data association (IrDA)) or the second network 2499 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 2492 may identify and authenticate the electronic device 2401 in a communication network, such as the first network 2498 or the second network 2499, using subscriber information (e.g., international mobile subscriber identity (IMSI)) stored in the subscriber identification module 2496.

The wireless communication module 2492 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 2492 may support a high-frequency band (e.g., the mmWave band) to achieve, e.g., a high data transmission rate. The wireless communication module 2492 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 2492 may support various requirements specified in the electronic device 2401, an external electronic device (e.g., the electronic device 2404), or a network system (e.g., the second network 2499). According to an embodiment, the wireless communication module 2492 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 2497 may transmit or receive a signal or power to or from the outside (e.g., the external electronic device) of the electronic device 2401. According to an embodiment, the antenna module 2497 may include an antenna including a radiating element composed of a conductive material or a conductive pattern formed in or on a substrate (e.g., a printed circuit board (PCB)). According to an embodiment, the antenna module 2497 may include a plurality of antennas (e.g., array antennas). In such a case, at least one antenna appropriate for a communication scheme used in the communication network, such as the first network 2498 or the second network 2499, may be selected, for example, by the communication module 2490 (e.g., the wireless communication module 2492) from the plurality of antennas. The signal or the power may then be transmitted or received between the communication module 2490 and the external electronic device via the selected at least one antenna. According to an embodiment, another component (e.g., a radio frequency integrated circuit (RFIC)) other than the radiating element may be additionally formed as part of the antenna module 2497.

According to various embodiments, the antenna module 2497 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 2401 and the external electronic device 2404 via the server 2408 coupled with the second network 2499. Each of the electronic devices 2402 or 2404 may be a device of a same type as, or a different type, from the electronic device 2401. According to an embodiment, all or some of operations to be executed at the electronic device 2401 may be executed at one or more of the external electronic devices 2402, 2404, or 2408. For example, if the electronic device 2401 should perform a function or a service automatically, or in response to a request from a user or another device, the electronic device 2401, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 2401. The electronic device 2401 may provide the outcome, with or without further processing of the outcome, as at least part of a reply to the request. To that end, a cloud computing, distributed computing, mobile edge computing (MEC), or client-server computing technology may be used, for example. The electronic device 2401 may provide ultra low-latency services using, e.g., distributed computing or mobile edge computing. In another embodiment, the external electronic device 2404 may include an internet-of-things (IoT) device. The server 2408 may be an intelligent server using machine learning and/or a neural network. According to an embodiment, the external electronic device 2404 or the server 2408 may be included in the second network 2499. The electronic device 2401 may be applied to intelligent services (e.g., smart home, smart city, smart car, or healthcare) based on 5G communication technology or IoT-related technology.

Problems to be solved according to an embodiment of the disclosure may be as follows.

According to an embodiment of the disclosure, a foldable electronic device including a supporting assembly which supports a flexible display folded or unfolded while the foldable electronic device is folded may be provided.

According to an embodiment of the disclosure, a foldable electronic device including a moving member which ascends to support a flexible display in an unfolded state of the foldable electronic device and descends not to interfere with the flexible display in a folded state of the foldable electronic device may be provided.

According to an embodiment of the disclosure, a foldable electronic device may include a foldable housing including a first housing, a second housing and a hinge housing. The foldable electronic device may include a hinge assembly disposed at least in part within the hinge housing, and rotatably connecting the first housing and the second housing. The foldable electronic device may include a flexible display crossing the hinge assembly, and disposed at least in part within the first housing and the second housing. The foldable electronic device may include a supporting assembly for supporting at least in part the flexible display. The supporting assembly may include a first fixing member coupled to the hinge housing. The supporting assembly may include a second fixing member coupled to the first fixing member. The supporting assembly may include a moving member configured to be movable within a space between the first fixing member and the second fixing member. In an unfolded state of the foldable electronic device, the moving member may be disposed at a first position, and one surface of the first fixing member and one surface of the moving member may support at least in part the flexible display. In an unfolded state of the foldable electronic device, the moving member is disposed at a first position, and one surface of the first fixing member and one surface of the moving member form substantially the same plane. In a folded state of the foldable electronic device, the moving member may be disposed at a second position moved from the first position, and the one surface of the moving member may form a step with the one surface of the first fixing member. In this context substantially the same plane means that the one surface of the first fixing member and the one surface of the moving member are arranged such that the average deviation from a common plane is less than 10% of the maximum height (in the z-direction) of the fixing member, more preferably less than 5%, more preferably less than 2% and most preferably 0%, i.e. they are in the same plane without any deviation from a common plane.

According to an embodiment of the disclosure, the moving member may include a first moving member and a second moving member. The second fixing member may include an inclined portion. While the foldable electronic device is folded, the first moving member may move along a first inclined surface of the inclined portion, and the second moving member may move along a second inclined surface of the inclined portion. According to an embodiment of the disclosure, the first inclined surface is configured to guide the movement of the first moving member and the second inclined surface is configured to guide the movement of the second moving member while the foldable electronic device is being folded or unfolded.

According to an embodiment of the disclosure, while the foldable electronic device is folded, as one surface of the first moving member and one surface of the second moving member facing the one surface of the first moving member move away from each other, the first moving member may move along the first inclined surface of the inclined portion, and the second moving member may move along the second inclined surface of the inclined portion.

According to an embodiment of the disclosure, while the foldable electronic device is being unfolded, as one surface of the first moving member and one surface of the second moving member facing the one surface of the first moving member move toward each other, the first moving member may move along the first inclined surface of the inclined portion, and the second moving member may move along the second inclined surface of the inclined portion, and thereby the first moving member and the second moving member move toward the flexible display.

According to an embodiment of the disclosure, the inclined portion of the second fixing member may include a seating surface formed between the first inclined surface and the second inclined surface. The first moving member and the second moving member may be disposed on the seating surface, in the folded state the foldable electronic device.

According to an embodiment of the disclosure, the hinge assembly may include a first rotating arm coupled to the first housing, and rotating about a first rotation axis. The hinge assembly may include a second rotating arm coupled to the second housing, and rotating about a second rotation axis parallel to the first rotation axis. While the foldable electronic device is unfolded, a first protrusion of the first rotating arm may lift the first moving member in a direction perpendicular to the first rotation axis. While the foldable electronic device is unfolded, a second protrusion of the second rotating arm may lift the second moving member in a direction perpendicular to the second rotation axis. This ensures stability of the hinge assembly in the unfolded state.

According to an embodiment of the disclosure, the hinge assembly may include a first rotating arm coupled to the first housing, and rotatable about a first rotation axis. The hinge assembly may include a second rotating arm coupled to the second housing, and rotatable about a second rotation axis parallel to the first rotation axis. While the foldable electronic device is being unfolded, a first protrusion of the first rotating arm may lift the first moving member in a lifting direction perpendicular to the first rotation axis and perpendicular to the second rotation axis. While the foldable electronic device is being unfolded, a second protrusion of the second rotating arm may lift the second moving member in the lifting direction.

According to an embodiment of the disclosure, while the foldable electronic device is unfolded, as the first moving member is lifted by the first protrusion, the first moving member may be moved along the first inclined surface. While the foldable electronic device is unfolded, as the second moving member is lifted by the second protrusion, the second moving member may be moved along the second inclined surface. While the foldable electronic device is unfolded, as the first moving member moves along the first inclined surface and the second moving member moves along the second inclined surface, the one surface of the first moving member and the one surface of the second moving member may move close to each other. According to an embodiment of the disclosure, in the unfolded state the foldable electronic device, the one surface of the first moving member and the one surface of the second moving member may be arranged to be in contact with each other.

According to an embodiment of the disclosure, in the unfolded state of the foldable electronic device, the first protrusion of the first rotating arm may support the first moving member, and the second protrusion of the second rotating arm may support the second moving member. This protects the flexible display from external pressure and/or shock.

According to an embodiment of the disclosure, while the foldable electronic device is folded, the first moving member may move in a first direction perpendicular to the first rotation axis and the second rotation axis, and the second moving member may move in a second direction opposite to the first direction.

According to an embodiment of the disclosure, an elastic member disposed between the first moving member and the second moving member may be further included. While the foldable electronic device is folded, the first moving member may be moved in the first direction and the second moving member may be moved in the second direction by an elastic force of the elastic member. According to an embodiment of the disclosure, the elastic member and/or the second elastic member may be formed as a plate-shaped spring (e.g. a leaf spring). According to an embodiment of the disclosure, while the foldable electronic device is being folded, the elastic member may be configured to move the first moving member and the second moving member in a direction away from the flexible display, wherein the direction away from the flexible display is perpendicular to first rotation axis and the second rotation axis and the first direction and the second direction. The direction away from the flexible display is opposite the lifting direction. According to an embodiment of the disclosure, while the foldable electronic device is being unfolded, the elastic member may be configured to move the first moving member away from the second moving member so as to disconnect the first moving member from the second moving member. The first direction is perpendicular to the lifting direction, the direction away from the flexible display, the first rotation axis and the second rotation axis.

According to an embodiment of the disclosure, a second elastic member disposed between the first moving member and the second moving member may be further included. While the foldable electronic device is folded, the first moving member may be moved in the first direction and the second moving member may be moved in the second direction by an elastic force of the second elastic member.

According to an embodiment of the disclosure, the first moving member may include a recess formed in the first direction. In the unfolded state of the foldable electronic device, the elastic member may be disposed between the second moving member and the recess.

According to an embodiment of the disclosure, the second moving member may include a recess formed in the second direction. In the unfolded state of the foldable electronic device, the second elastic member may be disposed between the second moving member and the recess formed in the second direction.

According to an embodiment of the disclosure, while the foldable electronic device is being unfolded, the elastic member may be compressed toward the first direction in contact with the second moving member. According to an embodiment of the disclosure, while the foldable electronic device is being unfolded, the elastic member may be compressed toward the first direction in contact with the second moving member, wherein the elastic member is not compressed in the lifting direction or the direction away from the flexible display. Thus, the stroke of the elastic member does not affect the thickness of the foldable electronic device. In the prior art, the drivetrain skew limits the thickness wise implementation, making it difficult to realize ultra-slim hinge structures. The present invention solves this using the elastic member according to the invention.

According to an embodiment of the disclosure, the first moving member may include a protrusion formed of an elastic material and protruding in the second direction. While the foldable electronic device is unfolded, the protrusion of the first moving member may be compressed toward the first direction in contact with the second moving member.

According to an embodiment of the disclosure, the second moving member may include a protrusion formed of an elastic material and protruding in the first direction. While the foldable electronic device is unfolded, the protrusion of the second moving member may be compressed toward the second direction in contact with the first moving member.

According to an embodiment of the disclosure, the first moving member may include a protrusion formed of an elastic material and protruding in the second direction and the second moving member may include a protrusion formed of an elastic material and protruding in the first direction.

According to an embodiment of the disclosure, the first moving member may include an opening penetrating the one surface of the first moving member and formed at a position adjacent to the protrusion of the first moving member. In the folded state of the foldable electronic device, the protrusion of the first moving member may be positioned at the position where the opening is formed.

According to an embodiment of the disclosure, the second moving member may include an opening penetrating the one surface of the second moving member and formed at a position adjacent to the protrusion of the second moving member. In the folded state of the foldable electronic device, the protrusion of the second moving member may be positioned at the position where the opening is formed.

According to an embodiment of the disclosure, while the foldable electronic device is folded, the first moving member may be moved in the first direction and the second moving member is moved in the second direction by an elastic force of the protrusion of the first moving member.

According to an embodiment of the disclosure, while the foldable electronic device is folded, the first moving member may be moved in the first direction and the second moving member is moved in the second direction by an elastic force of the protrusion of the second moving member.

According to an embodiment of the disclosure, the second fixing member may include a first magnetic body disposed on one side of the second fixing member and a second magnetic body disposed on the other side opposite to the one side of the second fixing member. The moving member may include a third magnetic body disposed on one side of the moving member and having a polarity opposite to the polarity of the first magnetic body, and a fourth magnetic body disposed on the other side opposite to the one side of the moving member and having a polarity opposite to the polarity of the second magnetic body. In the folded state of the foldable electronic device, the one side of the moving member may be disposed at a position adjacent to the one side of the second fixing member by attraction between the first magnetic body and the third magnetic body, and the other side of the moving member may be disposed at a position adjacent to the other side of the second fixing member by attraction between the second magnetic body and the fourth magnetic body. This creates space and curvature around the display banding and prevents the display from being crushed or scratched.

According to an embodiment of the disclosure, in the folded state of the foldable electronic device, a folding portion of the flexible display may be disposed at least in part between the one surface of the first fixing member and the one surface of the moving member. This creates space and curvature around the display banding and prevents the display from being crushed or scratched.

According to an embodiment of the disclosure, an end of the one surface of the first fixing member facing one side of the folding portion of the flexible display may be formed to have a specific curvature. This prevents damage to the flexible display from the one surface contacting the flexible display such as by stabbing and/or puncturing.

According to an embodiment of the disclosure, in the folded state of the foldable electronic device, the folding portion of the flexible display may be disposed at least in part in a concave portion formed by the step and the one surface of the moving member.

According to an embodiment of the disclosure, while the foldable electronic device is being folded or unfolded, the first fixing member and the second fixing member do not move. According to an embodiment of the disclosure, while the foldable electronic device is being folded or unfolded, of the elements that the supporting assembly is comprised of, only the moving member moves.

According to an embodiment of the disclosure, a foldable electronic device may include a foldable housing including a first housing, a second housing and a hinge housing. The foldable electronic device may include a hinge assembly disposed at least in part within the hinge housing, and rotatably connecting the first housing and the second housing. The foldable electronic device may include a flexible display crossing the hinge assembly, and disposed at least in part within the first housing and the second housing. The foldable electronic device may include a supporting assembly for supporting at least in part the flexible display. The supporting assembly may include a first fixing member coupled to the hinge housing. The supporting assembly may include a second fixing member coupled to the first fixing member. The supporting assembly may include a moving member configured to be movable within a space between the first fixing member and the second fixing member. In an unfolded state of the foldable electronic device, as the moving member is lifted, one surface of the moving member may support a folding portion of the flexible display. In a folded state of the foldable electronic device, as the moving member descends, the folding portion of the flexible display may be positioned at least in part within a recess formed by a side surface of the first fixing member and the one surface of the moving member.

According to an embodiment of the disclosure, the moving member may include a first moving member and a second moving member. The second fixing member may include an inclined portion. While the foldable electronic device is folded, the first moving member may move along a first inclined surface of the inclined portion, and the second moving member may move along a second inclined surface of the inclined portion.

According to an embodiment of the disclosure, while the foldable electronic device is folded, as one surface of the first moving member and one surface of the second moving member facing one surface of the first moving member are moved away from each other, the first moving member may move along the first inclined surface of the inclined portion and the second moving member may move along the second inclined surface of the inclined portion.

Effects of the invention according to an embodiment of the disclosure are as follows.

According to an embodiment of the disclosure, a foldable electronic device configured to lift or lower only a moving member of a supporting assembly supporting a flexible display of the foldable electronic device and to thus efficiently use a space between the flexible display and a hinge housing may be provided. Specifically, by designing only the moving member to be moved in a direction away from the flexible display, without having to secure a space between the supporting assembly and the flexible display, the supporting assembly can effectively utilize the narrow space of the hinge structure of the foldable electronic device. The fixing members stabilize the structure and guide the movement of the moving member.

According to an embodiment of the disclosure, a supporting assembly configured to support a folding portion of a flexible display with a moving member in an unfolded state of a foldable electronic device and to lower the moving member not to interfere with the folding portion of the flexible display in a folded state of the foldable electronic device may be provided.

Besides, various effects directly or indirectly obtained from the disclosure may be provided.

The methods according to the embodiments described in the claims or the specification of the disclosure may be implemented in software, hardware, or a combination of hardware and software.

In software implementation, a computer-readable storage medium storing one or more programs (software modules) may be provided. One or more programs stored in the computer-readable storage medium may be configured for execution by one or more processors of an electronic device. One or more programs may include instructions for controlling an electronic device to execute the methods according to the embodiments described in the claims or the specification of the disclosure.

Such a program (software module, software) may be stored to a random access memory, a non-volatile memory including a flash memory, a read only memory (ROM), an electrically erasable programmable ROM (EEPROM), a magnetic disc storage device, a CD-ROM, digital versatile discs (DVDs) or other optical storage devices, and a magnetic cassette. Alternatively, it may be stored to a memory combining part or all of them. In addition, a plurality of memories may be included.

Also, the program may be stored in an attachable storage device accessible via a communication network such as internet, intranet, local area network (LAN), wide LAN (WLAN), or storage area network (SAN), or a communication network by combining these networks. Such a storage device may access a device which executes an embodiment of the disclosure through an external port. In addition, a separate storage device on the communication network may access the device which executes an embodiment of the disclosure.

In the specific embodiments of the disclosure, the component included in the disclosure is expressed in a singular or plural form. However, the singular or plural expression is appropriately selected according to a proposed situation for the convenience of explanation, the disclosure is not limited to a single component or a plurality of components, the components expressed in the plural form may be configured as a single component, and the components expressed in the singular form may be configured as a plurality of components.

In addition, a term such as "unit" or "module" in the disclosure may be a hardware component such as a processor or a circuit, and/or a software component executed by a hardware component such as a processor.

"unit" and "module" may be stored in an addressable storage medium and implemented by a program executable by the processor. For example, "unit" and "module" may be implemented by components such as software components, object-oriented software components, class components and task components, processes, functions, attributes, procedures, sub-routines, segments of program code, drivers, firmware, microcode, circuit, data, databases, data structures, tables, arrays and variables.

Specific implementations described in this disclosure are merely embodiments, and are not intended to limit the scope of the disclosure in any way. For the sake of brevity of the specification, disclosure of conventional electronic configurations, control systems, software, and other functional aspects of the systems may be omitted.

In addition, in the disclosure, "including at least one of a, b, or c" may indicate "including a alone, including b alone, including c alone, including a and b, including b and c, including a and c, or including all of a, b, and c".

Meanwhile, while the specific embodiment has been described in the detailed explanation of the disclosure, it will be noted that various modifications may be made without departing from the scope of the disclosure. Therefore, the scope of the disclosure is not limited and defined by the described embodiment and is defined by not only the scope of the claims as below but also their equivalents.

## Claims

1. A foldable electronic device comprising:
a foldable housing comprising a first housing, a second housing and a hinge housing;
a hinge assembly disposed at least in part within the hinge housing, and rotatably connecting the first housing and the second housing;
a flexible display supported by the hinge assembly; and
a supporting assembly at least partially supporting the flexible display,
wherein the supporting assembly comprises:
a first fixing member coupled to the hinge housing;
a second fixing member coupled to the first fixing member; and
a moving member configured to be movable within a space between the first fixing member and the second fixing member,
wherein, in an unfolded state of the foldable electronic device, the moving member is disposed at a first position, and one surface of the first fixing member and one surface of the moving member form the substantially same plane, and
in a folded state of the foldable electronic device, the moving member is disposed at a second position moved from the first position, and the one surface of the moving member forms a step with the one surface of the first fixing member.

2. The foldable electronic device of claim 1, wherein the moving member comprises a first moving member and a second moving member,
the second fixing member comprises an inclined portion, and
wherein the foldable electronic device (300) is configured to, while the foldable electronic device is being folded, move the first moving member along a first inclined surface of the inclined portion, and move the second moving member along a second inclined surface of the inclined portion.

3. The foldable electronic device of claim 2, wherein, wherein the foldable electronic device (300) is configured to, while the foldable electronic device is being folded:
move as one surface of the first moving member and one surface of the second moving member facing the one surface of the first moving member away from each other, the first moving member moves along the first inclined surface of the inclined portion, and move the second moving member along the second inclined surface of the inclined portion.

4. The foldable electronic device of claim 2, wherein the inclined portion of the second fixing member comprises a seating surface formed between the first inclined surface and the second inclined surface, and
the first moving member and the second moving member are disposed on the seating surface, in the folded state the foldable electronic device.

5. The foldable electronic device of claim 2, wherein the hinge assembly comprises:
a first rotating arm coupled to the first housing, and rotatable about a first rotation axis; and
a second rotating arm coupled to the second housing, and rotatable about a second rotation axis parallel to the first rotation axis, and
while the foldable electronic device is being unfolded:
a first protrusion of the first rotating arm is configured to lift the first moving member in a lifting direction perpendicular to the first rotation axis and perpendicular to the second rotation axis, and
a second protrusion of the second rotating arm is configured to lift the second moving member in the lifting direction.

6. The foldable electronic device of claim 5, wherein, while the foldable electronic device is being unfolded:
the foldable electronic device (300) is configured to:
as the first moving member is lifted by the first protrusion, move the first moving member along the first inclined surface,
as the second moving member is lifted by the second protrusion, move the second moving member along the second inclined surface, and
as the first moving member moves along the first inclined surface and the second moving member moves along the second inclined surface, move the one surface of the first moving member and the one surface of the second moving member toward each other.

7. The foldable electronic device of claim 5, wherein, in the unfolded state of the foldable electronic device, the first protrusion of the first rotating arm is configured to support the first moving member, and the second protrusion of the second rotating arm is configured to support the second moving member.

8. The foldable electronic device of claim 5, wherein, while the foldable electronic device is being folded, the foldable electronic device (300) is configured to move the first moving member in a first direction perpendicular to the first rotation axis and the second rotation axis, and move the second moving member in a second direction opposite to the first direction.

9. The foldable electronic device of claim 8, further comprising:
an elastic member disposed between the first moving member and the second moving member,
wherein, while the foldable electronic device is being folded, the foldable electronic device (300) is configured to move the first moving member in the first direction and move the second moving member in the second direction by an elastic force of the elastic member.

10. The foldable electronic device of claim 9, wherein the first moving member comprises a recess formed in the first direction, and
in the unfolded state of the foldable electronic device, the elastic member is disposed between the second moving member and the recess.

11. The foldable electronic device of claim 8, wherein the first moving member comprises a protrusion formed of an elastic material and protruding in the second direction, and
while the foldable electronic device is being unfolded, the foldable electronic device is configured to compress the protrusion of the first moving member toward the first direction in contact with the second moving member.

12. The foldable electronic device of claim 11, wherein the first moving member comprises an opening penetrating the one surface of the first moving member and formed at a position adjacent to the protrusion of the first moving member, and
in the folded state of the foldable electronic device, the protrusion of the first moving member is positioned at the position where the opening is formed.

13. The foldable electronic device of claim 11, wherein, while the foldable electronic device is being folded, the foldable electronic device is configured to move the first moving member in the first direction and move the second moving member in the second direction by an elastic force of the protrusion of the first moving member.

14. The foldable electronic device of claim 1, wherein the second fixing member comprises a first magnetic body disposed on one side of the second fixing member and a second magnetic body disposed on the other side opposite to the one side of the second fixing member,
the moving member comprises a third magnetic body disposed on one side of the moving member and having a polarity opposite to the polarity of the first magnetic body, and a fourth magnetic body disposed on the other side opposite to the one side of the moving member and having a polarity opposite to the polarity of the second magnetic body, and
in the folded state of the foldable electronic device:
the one side of the moving member is disposed at a position adjacent to the one side of the second fixing member by attraction between the first magnetic body and the third magnetic body, and
the other side of the moving member is disposed at a position adjacent to the other side of the second fixing member by attraction between the second magnetic body and the fourth magnetic body.

15. A foldable electronic device comprising:
a foldable housing comprising a first housing, a second housing and a hinge housing;
a hinge assembly disposed at least in part within the hinge housing, and rotatably connecting the first housing and the second housing;
a flexible display crossing the hinge assembly, and disposed at least in part within the first housing and the second housing; and
a supporting assembly for supporting at least in part the flexible display,
wherein the supporting assembly comprises:
a first fixing member coupled to the hinge housing;
a second fixing member coupled to the first fixing member; and
a moving member configured to be movable within a space between the first fixing member and the second fixing member,
wherein, in an unfolded state of the foldable electronic device, as the moving member is lifted, one surface of the moving member forms the substantially same plane, and
in a folded state of the foldable electronic device, as the moving member descends, the folding portion of the flexible display is positioned at least in part within a recess formed by a side surface of the first fixing member and the one surface of the moving member.
